# EUROPEAN PATENT APPLICATION

(11) **EP 4 692 141 A1**
(43) Date of publication of application: **11.02.2026**
(21) Application number: 24784728.8
(22) Date of filing: 21.03.2024
(51) Int. Cl.: C08F 220/18, C09D 133/14, G03F 7/004

(54) **COPOLYMER AND COATING COMPOSITION OR RESIST COMPOSITION CONTAINING COPOLYMER**

(30) Priority: 06.04.2023 JP 2023061960
(71) Applicant: DIC Corporation, Tokyo 174-8520 (JP)
(72) Inventor: DOI, Sawako, Ichihara-shi, Chiba 290-8585 (JP); HATASE, Masaki, Ichihara-shi, Chiba 290-8585 (JP); UENO, Junpei, Ichihara-shi, Chiba 290-8585 (JP); SHIMIZU, Ryohei, Ichihara-shi, Chiba 290-8585 (JP); SUZUKI, Hideya, Ichihara-shi, Chiba 290-8585 (JP)
(74) Representative: Kraus & Lederer PartGmbB
(86) International application number: PCT/JP2024/010922
(87) International publication number: WO 2024/209937

(57) **Abstract**

Provided is a copolymer that can function as a leveling agent imparting high smoothness to a coating film even when added in small amounts. The copolymer contains at least a polymerizable monomer (a1) and a polymerizable monomer (a2) as polymerizable components.

The polymerizable monomer (a1) contains a functional group represented by -Si[OSi(R)₃]ₙ[R']₃₋ₙ (where n is an integer of 1 to 3, R each independently represents an alkyl group having from 1 to 3 carbon atoms, and R' each independently represents an alkyl group having from 1 to 3 carbon atoms) and an acryloyl group. The polymerizable monomer (a2) contains one or more selected from the group consisting of an alkyl group having from 1 to 18 carbon atoms, an aromatic group having from 6 to 18 carbon atoms, a group containing a polyoxyalkylene chain, and a group containing a polyester chain.

## Description

### TECHNICAL FIELD

The present invention relates to a copolymer and a coating composition or resist composition containing the copolymer.

### BACKGROUND ART

A leveling agent is added to achieve a smooth surface of a coating film that is obtained by applying a coating composition such as a coating composition or a resist composition. Specifically, when a leveling agent is added to a coating composition, the leveling agent is oriented on the surface of the coating film and reduces the surface tension of the coating film, whereby an effect of smoothing the resulting coating film is provided. The occurrence of cissing and heterogeneity can be reduced on the coating film with a smooth surface.

A leveling agent is used, for example, in automotive coating materials, and a coating composition containing a leveling agent can impart a high smoothness to the surface of the resulting coating film and can impart gloss to the appearance of automobiles.
As a leveling agent used for automotive coating materials, a silicone-based leveling agent has been proposed (Patent Document 1).

A leveling agent can be used in various applications, and its use is not limited to a coating material as described above. For use other than coating materials, a leveling agent is also added in a resist composition, and a leveling agent for the resist is also proposed (Patent Document 2).

### CITATION LIST

### PATENT DOCUMENT

Patent Document 1: JP 2003-226834 A
Patent Document 2: WO 2021/131726

### SUMMARY OF INVENTION

### TECHNICAL PROBLEM

For use in a resist which requires miniaturization to a nanometer order, there is a need for reducing additives contained in a resist to the greatest extent possible, as the additives contained may negatively affect the miniaturization treatment, and a leveling agent that can achieve a leveling effect even when added in small amounts is desired.
In the silicone-based leveling agent described in Patent Documents 1 and 2, silicone (meth)acrylate is disclosed as a silicone monomer; however, the leveling agent actually evaluated in Examples uses silicone methacrylate. A main chain composed of the methacrylate backbone does not achieve a satisfactory leveling effect due to rigidity of the main chain, and a considerable amount needs to be added to achieve the desired leveling effect (Patent Documents 1 and 2).

An object of the present invention is to provide a copolymer that can function as a leveling agent imparting high smoothness to a coating film even when added in small amounts.
Another object of the present invention is to provide a coating composition that can form a coating film exhibiting high smoothness even at low leveling agent content.
Another object of the present invention is to provide a coating film exhibiting high smoothness even at low leveling agent content.

### SOLUTION TO PROBLEM

As a result of diligent research to solve the issues described above, the inventors of the present invention have found a copolymer that can achieve high leveling properties that is acceptable for resist use even when added in small amounts, the copolymer containing at least a polymerizable monomer (a1) and a polymerizable monomer (a2) as polymerizable components: the polymerizable monomer (a1) containing a functional group represented by - Si[OSi(R)₃]ₙ[R']₃₋ₙ (where n is an integer in a range of from 1 to 3, R each independently represents an alkyl group having from 1 to 3 carbon atoms, and R' each independently represents an alkyl group having from 1 to 3 carbon atoms) and an acryloyl group; and the polymerizable monomer (a2) containing one or more selected from the group consisting of an alkyl group having from 1 to 18 carbon atoms, an aromatic group having from 6 to 18 carbon atoms, a group containing a polyoxyalkylene chain, and a group containing a polyester chain and thus completed the present invention.

That is, the present invention relates to the following copolymer and the like.

### ADVANTAGEOUS EFFECTS OF INVENTION

The present invention can provide a copolymer that can function as a leveling agent imparting high smoothness to a coating film even when added in small amounts.

The present invention can provide a coating composition that can form a cured product exhibiting high smoothness even when the content of a leveling agent is small.

The present invention can provide a cured product exhibiting high smoothness even when the content of a leveling agent is small.

### DESCRIPTION OF EMBODIMENTS

Hereinafter, an embodiment of the present invention will be described. The present invention is not limited by the following embodiments, and modification can be appropriately applied in a range that does not impair the effect of the present invention.
Note that, in the description of the present application, the term "(meth)acrylate" refers to one or both of acrylate and methacrylate.

### Copolymer

The copolymer of the present invention is a copolymer containing at least a polymerizable monomer (a1) and a polymerizable monomer (a2) as polymerizable components:
the polymerizable monomer (a1) containing a functional group represented by - Si[OSi(R)₃]ₙ[R']₃₋ₙ (where n is an integer in a range of from 1 to 3, R each independently represents an alkyl group having from 1 to 3 carbon atoms, and R' each independently represents an alkyl group having from 1 to 3 carbon atoms) and an acryloyl group; and a polymerizable monomer (a2) containing one or more selected from the group consisting of an alkyl group having from 1 to 18 carbon atoms, an aromatic group having from 6 to 18 carbon atoms, a group containing a polyoxyalkylene chain, and a group containing a polyester chain.

Note that the term "polymerizable component" means a component constituting a copolymer of the present invention and means that a component that does not constitute the copolymer of the present invention, such as a solvent and a polymerization initiator, is not contained.

In the present invention, the term "polymerizable monomer" means a compound having a polymerizable unsaturated group, and the polymerizable monomer (a1) contains an acryloyl group as a polymerizable unsaturated group.
When the polymerizable unsaturated group of the polymerizable monomer (a1) having surface segregation ability is an acryloyl group in the copolymer of the present invention, a portion exhibiting surface segregation ability in the main chain structure of the copolymer becomes a flexible acryloyl backbone, and thus the surface segregation ability of the copolymer can be enhanced.
The acryloyl group that is a polymerizable unsaturated group of the polymerizable monomer (a1) is preferably an acryloyloxy group (acrylate group (CH₂=CH-C(=O)-O- group)).

The number of the polymerizable unsaturated groups contained in the polymerizable monomer may be 1 or may be 2 or more.

Hereinafter, the polymerizable monomer (a1) and the polymerizable monomer (a2) constituting the copolymer of the present invention will each be described.

In the polymerizable monomer (a1), the functional group represented by -Si[OSi(R)₃]ₙ[R']₃₋ₙ is preferably a functional group represented by - Si[OSi(R)₃]₃, and more preferably -Si[OSi(CH₃)₃]₃. When the functional group represented by -Si[OSi(R)₃]ₙ[R']₃₋ₙ is -Si[OSi(CH₃)₃]₃, the copolymer of the present invention can have a higher surface segregation ability.

The polymerizable monomer (a1) is preferably a compound represented by the following Formula (a1-1). 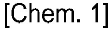 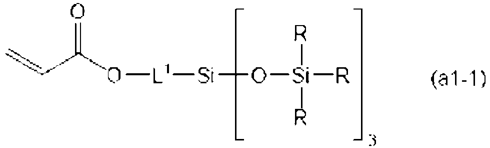 (In Formula (a1-1),
R each independently represents an alkyl group having from 1 to 3 carbon atoms, and
L¹ is a divalent organic group or a single bond).

The term "single bond" for L¹ means a case where O and Si are directly bonded.
The divalent organic group of L¹ is preferably an alkylene group having from 1 to 50 carbon atoms, or an alkyleneoxy group having from 1 to 50 carbon atoms.

Examples of the alkylene group having from 1 to 50 carbon atoms in L¹ include a methylene group, an ethylene group, an n-propylene group, an n-butylene group, an n-pentylene group, an n-hexylene group, an n-heptylene group, an n-octylene group, an n-nonylene group, an n-decylene group, an n-dodecylene group, an isopropylene group, a 2-methylpropylene group, a 2-methylhexylene group, and a tetramethylethylene group.

The alkylene group having from 1 to 50 carbon atoms in L¹ is preferably an alkylene group having from 1 to 15 carbon atoms, more preferably an alkylene group having from 1 to 5 carbon atoms, and still more preferably a methylene group, an ethylene group, a n-propylene group, or an isopropylene group.

The alkyleneoxy group having from 1 to 50 carbon atoms in L¹ is, for example, a group in which one or more -CH₂- in the alkylene group are substituted with -O-.
The alkyleneoxy group having from 1 to 50 carbon atoms in L¹ is preferably an alkyleneoxy group having from 1 to 15 carbon atoms, more preferably an alkyleneoxy group having from 1 to 8 carbon atoms, and still more preferably a methyleneoxy group, an ethyleneoxy group, a propyleneoxy group, an oxytrimethylene group, a butyleneoxy group, an oxytetramethylene group, a pentyleneoxy group, a heptyleneoxy group or an octyleneoxy group.

When the divalent organic group in L¹ is an alkylene group having from 1 to 50 carbon atoms or an alkyleneoxy group having from 1 to 50 carbon atoms, in these divalent organic groups, some -CH₂- may be replaced with a carbonyl group (-C(=O)-), a phenylene group, an amide bond, or a urethane bond.

When the divalent organic group of L¹ is an alkylene group having from 1 to 50 carbon atoms or an alkyleneoxy group having from 1 to 50 carbon atoms, a substituent such as a hydroxyl group may be substituted on a carbon atom of these groups.

The functional group represented by -Si[OSi(R)₃]₃ in the compound represented by Formula (a1-1) is preferably -Si[OSi(CH₃)₃]₃, and the compound is represented by the following Formula (a1-2). 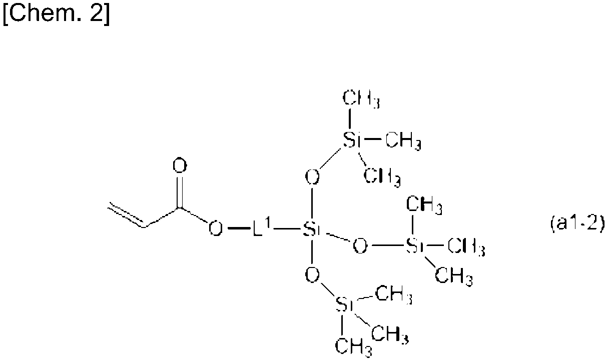 (In Formula (a1-2),
L¹ is a divalent organic group or a single bond)

The polymerizable monomer (a1) can be produced by a known method, and a commercially available product thereof may be used.
As the commercially available product of the polymerizable monomer (a1), for example, 3-acryloyloxypropyltris(trimethylsiloxy) silane is commercially available.

In the copolymer of the present invention, the lower limit of the percentage of the polymerizable monomer (a1) content is, relative to the total amount of the polymerizable components of the copolymer, for example, 5 mass% or more, and preferably in the order of 10 mass% or more, 15 mass% or more, 20 mass% or more, 30 mass% or more, 50 mass% or more, 60 mass% or more, and 65 mass% or more.
The upper limit of the percentage of the polymerizable monomer (a1) content is not particularly limited and is, relative to the total amount of the copolymer, for example, 95 mass% or less, preferably 90 mass% or less, more preferably 85 mass% or less, and even more preferably 75 mass% or less.
Examples of the combination of the upper limit and the lower limit of the percentage of the polymerizable monomer (a1) content include a range of from 20 mass% to 90 mass% of the total amount of the polymerizable components of the copolymer.
The percentage of the polymerizable monomer (a1) content can be adjusted based on the feed ratio of raw materials of the polymerizable monomer (a1) in producing the copolymer of the present invention.

The percentage of the content of the functional group represented by -Si[OSi(R)₃]ₙ[R']₃₋ₙ in the copolymer of the present invention is, for example, in a range of from 5 to 95 mass%, preferably in a range of from 10 to 90 mass%, more preferably in a range of from 20 to 80 mass%, and even more preferably in a range of from 30 to 70 mass%, and particularly preferably in a range of from 35 to 65 mass%, of the total amount of the copolymer.
The content of the functional group represented by -Si[OSi(R)₃]ₙ[R']₃₋ₙ can be adjusted based on the feed ratio of the raw materials of the polymerizable monomer (a1) in producing the copolymer of the present invention.

The polymerizable monomer (a2) is a polymerizable monomer containing one or more selected from the group consisting of an alkyl group having from 1 to 18 carbon atoms, an aromatic group having from 6 to 18 carbon atoms, a group containing a polyoxyalkylene chain, and a group containing a polyester chain.

Examples of the polymerizable unsaturated group included in the polymerizable monomer (a2) include a C=C containing group, such as a (meth)acryloyl group, a (meth)acryloyloxy group, a (meth)acryloylamino group, a vinyl ether group, an allyl group, a styryl group, and a maleimide group. Among these, for the ease of availability of raw materials and good polymerization reactivity, a (meth)acryloyl group or a (meth)acryloyloxy group is preferable, an acryloyl group is more preferable, and an acryloyloxy group (acrylate group (CH₂=CH-C(=O)-O- group)) is even more preferable.

When the polymerizable unsaturated group contained in the polymerizable monomer (a2) is the acryloyl group, both of the portion exhibiting surface segregation ability (structure derived from the polymerizable monomer (a1)) and the portion exhibiting miscibility (structure derived from the polymerizable monomer (a2)) in the main chain structure of the copolymer of the present invention become a flexible acryloyl backbone, "pin mura" of the cured film obtained from the coating composition described below can be suppressed. Regarding the term "pin mura", the coating composition is typically dried in a vacuum drying apparatus to vaporize the solvent in the coating film after the film formation, and the coating film on the base material is dried while being supported on supporting pins in the drying apparatus chamber. At this time, the temperature difference between the part at which the supporting pins and the base material are in contact with each other and the part that is not arises, and unevenness after the drying of the coating film due to the difference in drying speed is referred to as "pin mura".

The alkyl group having from 1 to 18 carbon atoms included in the polymerizable monomer (a2) may be any of a linear alkyl group, a branched alkyl group, or a cyclic alkyl group, and specific examples thereof include a methyl group, an ethyl group, a normal propyl group, an isopropyl group, an n-butyl group, a t-butyl group, an n-hexyl group, a cyclohexyl group, an n-octyl group, and a hexadecyl group.
The alkyl group having from 1 to 18 carbon atoms included in the polymerizable monomer (a2) is preferably an alkyl group having from 1 to 6 carbon atoms.

Examples of the aromatic group having from 6 to 18 carbon atoms included in the polymerizable monomer (a2) include a phenyl group, a naphthyl group, an anthracene-1-yl group, and a phenanthrene-1-yl group.

The group containing a (poly)oxyalkylene chain included in the polymerizable monomer (a2) is a monovalent group containing a repeating moiety of oxyalkylene or a divalent linking group containing a repeating moiety of oxyalkylene.

The group containing a polyester chain included in the polymerizable monomer (a2) is a monovalent group containing a repeating moiety of ester bonding or a divalent linking group containing a repeating moiety of ester bonding.

The alkyl group having from 1 to 18 carbon atoms included in the polymerizable monomer (a2) may further contain a substituent, and examples of the substituent include a hydroxyl group and an aryl group.
The aromatic group having from 6 to 18 carbon atoms included in the polymerizable monomer (a2) may further contain a substituent, and examples of the substituent include a hydroxyl group and an alkyl group.

The polymerizable monomer (a2) may be, for example, one or more selected from the group consisting of a polymerizable monomer containing an alkyl group having from 1 to 18 carbon atoms, a polymerizable monomer containing an aromatic group having from 6 to 18 carbon atoms, a polymerizable monomer containing a group containing a polyoxyalkylene chain, and a polymerizable monomer containing a group containing a polyester chain. The polymerizable monomer (a2) essentially containing a polymerizable monomer having a group containing a polyoxyalkylene chain is preferable .

Examples of the polymerizable monomer (a2) that includes an alkyl group having from 1 to 18 carbon atoms and whose polymerizable unsaturated group is a (meth)acryloyl group include: alkyl esters having from 1 to 18 carbon atoms of (meth)acrylic acid, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, t-butyl (meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, and isostearyl (meth)acrylate; and bridged cyclic alkyl esters having from 1 to 18 carbon atoms of (meth)acrylic acid, such as dicyclopentanyloxylethyl (meth)acrylate, isobornyloxylethyl (meth)acrylate, isobornyl (meth)acrylate, adamantyl (meth)acrylate, dimethyladamantyl (meth)acrylate, dicyclopentanyl (meth)acrylate, and dicyclopentenyl (meth)acrylate.

Examples of the polymerizable monomer (a2) that includes a hydroxyalkyl group having from 1 to 18 carbon atoms and whose polymerizable unsaturated group is a (meth)acryloyl group include: 2-hydroxyethyl (meth)acrylate, 2-hydroxypropyl (meth)acrylate, 2-hydroxybutyl (meth)acrylate, 4-hydroxy (meth)acrylate, 1,4-cyclohexanedimethanol mono(meth)acrylate, and 2,3-dihydroxypropyl (meth)acrylate.

Examples of the polymerizable monomer (a2) that includes a phenylalkyl group having from 7 to 18 carbon atoms or a phenoxyalkyl group having from 7 to 18 carbon atoms and whose polymerizable unsaturated group is a (meth)acryloyl group include benzyl (meth)acrylate, 2-phenoxymethyl (meth)acrylate, 2-phenoxyethyl (meth)acrylate, and 2-hydroxy-3-phenoxypropyl (meth)acrylate.

Examples of the polymerizable monomer (a2) that has a group including a polyoxyalkylene chain and whose polymerizable unsaturated group is a (meth)acryloyl group include polypropylene glycol mono(meth)acrylate, polyethylene glycol mono(meth)acrylate, polytrimethylene glycol mono(meth)acrylate, polytetramethylene glycol mono(meth)acrylate, poly(ethylene glycol/propylene glycol) mono(meth)acrylate, polyethylene glycol/polypropylene glycol mono(meth)acrylate, poly(ethylene glycol/tetramethylene glycol) mono(meth)acrylate, polyethylene glycol/polytetramethylene glycol mono(meth)acrylate, poly(propylene glycol/tetramethylene glycol) mono(meth)acrylate, polypropylene glycol/polytetramethylene glycol mono(meth)acrylate, poly(propylene glycol/1,2-butylene glycol) mono(meth)acrylate, polypropylene glycol/poly(1,2-butylene glycol) mono(meth)acrylate, poly(ethylene glycol/1,2-butylene glycol) mono(meth)acrylate, polyethylene glycol/poly(1,2-butylene glycol) mono(meth)acrylate, poly(tetraethylene glycol/1,2-butylene glycol) mono(meth)acrylate, polytetraethylene glycol/poly(1,2-butylene glycol) mono(meth)acrylate, poly(1,2-butylene glycol) mono(meth)acrylate, poly(ethylene glycol/trimethylene glycol) mono(meth)acrylate, poly(ethylene glycol/trimethylene glycol) mono(meth)acrylate, polyethylene glycol/polytrimethylene glycol mono(meth)acrylate, poly(propylene glycol/trimethylene glycol) mono(meth)acrylate, polypropylene glycol/polytrimethylene glycol mono(meth)acrylate, poly(trimethylene glycol/tetramethylene glycol) mono(meth)acrylate, polytrimethylene glycol/polytetramethylene glycol mono(meth)acrylate, poly(1,2-butylene glycol/trimethylene glycol) mono(meth)acrylate, poly(1,2-butylene glycol/polytrimethylene glycol) mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol/tetramethylene glycol) mono(meth)acrylate, and poly(1,2-butylene glycol/polytetramethylene glycol) mono(meth)acrylate.
Note that, the term "poly(ethylene glycol/propylene glycol)" means a random copolymer of ethylene glycol and propylene glycol, and the term "polyethylene glycol/polypropylene glycol" means a block copolymer of ethylene glycol and propylene glycol.

Examples of the polymerizable monomer (a2) that has an alkyl group having from 1 to 18 carbon atoms and whose polymerizable unsaturated group is a vinyl ether group include: alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethylhexyl vinyl ether, and cyclohexyl vinyl ether, cycloalkyl vinyl ether, 2-hydroxyethyl vinyl ether, 3-hydroxypropyl vinyl ether, 4-hydroxybutyl vinyl ether, 5-hydroxypentyl vinyl ether, 6-hydroxyhexyl vinyl ether, 1-hydroxypropyl vinyl ether, 2-hydroxypropyl vinyl ether, 1-hydroxybutyl vinyl ether, 2-hydroxybutyl vinyl ether, 3-hydroxybutyl vinyl ether, 3-hydroxy-2-methylpropyl vinyl ether, 4-hydroxy-2-methylbutyl vinyl ether, 4-hydroxycyclohexyl vinyl ether, and cyclohexane-1,4-dimethanol monovinyl ether.

Examples of the polymerizable monomer (a2) that has an alkyl group having from 1 to 18 carbon atoms and whose polymerizable unsaturated group is an allyl group include 2-hydroxyethyl allyl ether, 4-hydroxybutyl allyl ether, and glycerol monoallyl ether.

Examples of the polymerizable monomer (a2) including an aromatic group having from 6 to 18 carbon atoms include styrene, α-methylstyrene, p-methylstyrene, and p-methoxystyrene.

Examples of the polymerizable monomer (a2) that has an alkyl group having from 1 to 18 carbon atoms and whose polymerizable unsaturated group is a (meth)acryloylamino group include N,N-dimethylacrylamide, N,N-diethylacrylamide, N-isopropylacrylamide, diacetone acrylamide, and acryloyl morpholine.

Examples of the polymerizable monomer (a2) that includes an alkyl group having from 1 to 18 carbon atoms and whose polymerizable unsaturated group is a maleimide group include methylmaleimide, ethylmaleimide, propylmaleimide, butylmaleimide, hexylmaleimide, octylmaleimide, dodecylmaleimide, stearylmaleimide, and cyclohexylmaleimide.

The polymerizable monomer (a2) is preferably one or more selected from the group consisting of a compound represented by the following Formula (a2-1), a compound represented by the following Formula (a2-2), a compound represented by the following Formula (a2-3), a compound represented by the following Formula (a2-4), and a compound represented by the following Formula (a2-5), and more preferably one or more selected from the group consisting of a compound represented by the following Formula (a2-1), a compound represented by the following Formula (a2-2), a compound represented by the following Formula (a2-3), and a compound represented by the following Formula (a2-4). These compounds can exhibit high miscibility when the copolymer of the present invention is used as a leveling agent. 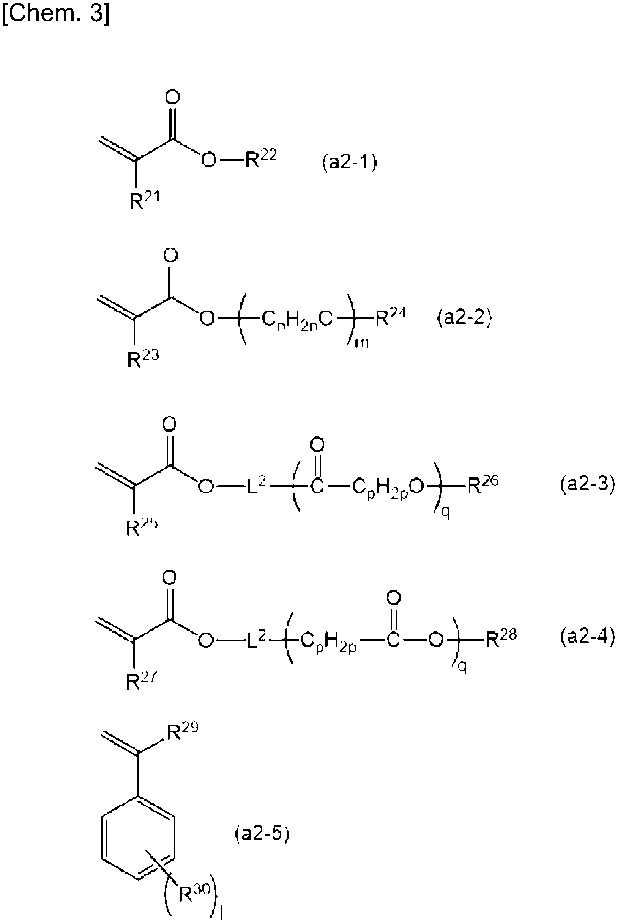 (In Formulas (a2-1), (a2-2), (a2-3), (a2-4), and (a2-5),
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms,
R²⁵ is a hydrogen atom or a methyl group,
R²⁶ is a hydrogen atom, an alkyl group having from 1 to 18 carbon atoms, or
an alkyl group containing an ether bond having from 1 to 18 carbon atoms,
R²⁷ is a hydrogen atom or a methyl group,
R²⁸ is a hydrogen atom, an alkyl group having from 1 to 18 carbon atoms, or an alkyl group containing an ether bond having from 1 to 18 carbon atoms,
L² is a divalent organic group or a single bond,
R²⁹ is a hydrogen atom or a methyl group,
R³⁰ is each independently an alkyl group having from 1 to 6 carbon atoms or an alkoxy group having from 1 to 6 carbon atoms,
n is an integer in a range of from 1 to 4, m represents the number of repeating units, p is an integer in a range of from 1 to 10, q represents the number of repeating units, and I is an integer in a range of from 0 to 5)

In Formula (a2-2), m instances of n inside the parentheses may be the same or different from each other.
In Formula (a2-3), q instances of p inside the parentheses may be the same or different from each other.
In Formula (a2-4), q instances of p inside the parentheses may be the same or different from each other.

The alkyl group having from 1 to 18 carbon atoms of R²², R²⁴, R²⁶, and R²⁸ may further contain a substituent, and examples of the substituent include a hydroxyl group and an aryl group.
The alkyl group containing an ether bond having from 1 to 18 carbon atoms of R²⁶ and R²⁸ may further contain a substituent, and examples of the substituent include a hydroxyl group and an aryl group.
The alkyl group having from 1 to 6 carbon atoms of R³⁰ may further contain a substituent, and examples of the substituent include a hydroxyl group and an aryl group.
The alkoxy group having from 1 to 6 carbon atoms of R³⁰ may further contain a substituent, and examples of the substituent include a hydroxyl group and an aryl group.

Examples of the divalent organic group of L² in Formulas (a2-3) and (a2-4) include those the same as the divalent organic group for L¹.

In all the compounds represented by Formulas (a2-1), (a2-2), (a2-3), (a2-4), and (a2-5), the polymerizable unsaturated group is preferably an acryloyl group. That is, R²¹, R²³, R²⁵, R²⁷, and R²⁹ are each preferably a hydrogen atom.

In General Formula (a2-2), m represents the number of repeating units and, for example, m may be an integer of 1 or greater. The number average of m is, for example, in a range of from 1 to 200, preferably in a range of from 1 to 150, and more preferably in a range of from 1 to 100.
The number average value for m can be confirmed by measuring a number average molecular weight of the polymerizable monomer (a2) by a method described in Examples.

In General Formulas (a2-3) and (a2-4), q represents the number of repeating units and, for example, q may be an integer of 1 or greater. The number average of q is, for example, in a range of from 1 to 100, preferably in a range of from 1 to 80, and more preferably in a range of from 1 to 50.
The number average value for q can be confirmed by measuring a number average molecular weight of the polymerizable monomer (a2) by a method described in Examples.

The polymerizable monomer (a2) preferably contains one or more selected from the group consisting of the compound represented by Formula (a2-2), the compound represented by Formula (a2-3), and the compound represented by Formula (a2-4).
In a case where the polymerizable monomer (a2) contains one or more selected from the group consisting of the compound represented by Formula (a2-2), the compound represented by Formula (a2-3), and the compound represented by Formula (a2-4), the total amount of the compound represented by Formula (a2-2), the compound represented by Formula (a2-3), and Formula (a2-4) is preferably 50 mass% or more, relative to the total amount of the polymerizable monomer (a2).

The polymerizable monomer (a2) can be produced by a known method. Alternatively, a commercially available product of the polymerizable monomer (a2) may be used. Examples of the commercially available products of the polymerizable monomer (a2) that has a group including a polyoxyalkylene chain and whose polymerizable unsaturated group is a (meth)acryloyl group include: "NK Ester M-20G", "NK Ester M-40G", "NK Ester M-90G","NK Ester M-230G", "NK Ester AM-90G", "NK Ester AMP-10G", "NK Ester AMP-20G", "NK Ester AMP-60G", which are available from Shin-Nakamura Chemical Co., Ltd.; "BLEMMER PE-90", "BLEMMER PE-200", "BLEMMER PE-350", "BLEMMER PME-100", "BLEMMER PME-200", "BLEMMER PME-400", "BLEMMER PME-4000", "BLEMMER PP-1000", "BLEMMER PP-500", "BLEMMER PP-800", "BLEMMER 70PEP-350B", "BLEMMER 55PET-800", "BLEMMER 50POEP-800B", "BLEMMER 10PPB-500B", "BLEMMER NKH-5050", "BLEMMER AP-400", "BLEMMER AE-350", which are available from NOF Corporation; PLACCEL F series available from Daicel Corporation; and Viscoat series available from Osaka Organic Chemical Industry Ltd.

The form of the polymerization of the copolymer of the present invention is not particularly limited and may be a random polymer structure of the polymerizable monomer (a1) and the polymerizable monomer (a2) or a block polymer structure of the polymerizable monomer (a1) and the polymerizable monomer (a2).

The copolymer of the present invention is preferably a block copolymer of a polymer block (A1) of the polymerizable monomer (a1) and a polymer block (A2) of the polymerizable monomer (a2).
The polymer block (A1) is a segment in which two or more of the polymerizable monomers (a1) are polymerized, and the polymer block (A2) is a segment in which two or more of the polymerizable monomers (a2) are polymerized.

When the copolymer of the present invention is a block copolymer of the polymer block (A1) and the polymer block (A2), recoatability can be enhanced.
In a multilayer resist processing, a plurality of resist layers is formed by applying multiple layers of a resist composition; however, in a case where the resist layers contain a leveling agent, wettability of the resist layer may be lowered due to surface tension reduction performance of the leveling agent, and thus it may become difficult to further form a layer on the resist layers. This ease of forming another layer on the resist layers is referred to as "recoatability".
In a case where the copolymer of the present invention is a block copolymer of the polymer block (A1) and the polymer block (A2), recoatability described above can be enhanced.

In a case where the copolymer of the present invention is a block copolymer of a polymer block (A1) of the polymerizable monomer (a1) and a polymer block (A2) of the polymerizable monomer (a2), as long as the polymerizable monomer constituting the polymer block (A1) is the polymerizable monomer (a1), the polymer block (A1) may contain two or more polymerizable monomers (a1) having structures different from each other. At this time, the form of the polymerization of the polymer block (A1) is not particularly limited, and the polymer block (A1) may have a random polymer structure of two or more polymerizable monomers (a1) having structures different from each other or may have a block polymer structure of two or more polymerizable monomers (a1) having structures different from each other.
The polymerizable monomer constituting the polymer block (A1) is preferably a single type of polymerizable monomer (a1).

In a case where the copolymer of the present invention is a block copolymer of a polymer block (A1) of the polymerizable monomer (a1) and a polymer block (A2) of the polymerizable monomer (a2), the polymerizable monomer constituting the polymer block (A2) may be the polymerizable monomer (a2), and the polymer block (A2) may contain two or more polymerizable monomers (a2) having structures different from each other. At this time, the form of the polymerization of the polymer block (A2) is not particularly limited, and the polymer block (A2) may have a random polymer structure of two or more polymerizable monomers (a2) having structures different from each other or may have a block polymer structure of two or more polymerizable monomers (a2) having structures different from each other.
The polymerizable monomer constituting the polymer block (A2) is preferably a single type of polymerizable monomer (a2).

In a case where the copolymer of the present invention is a block copolymer of a polymer block (A1) of the polymerizable monomer (a1) and a polymer block (A2) of the polymerizable monomer (a2), as long as the block copolymer of the present invention contains at least one polymer block (A1) and at least one polymer block (A2), the number of each of the polymer blocks and the bonding order are not particularly limited.
The block copolymer of the present invention is preferably a diblock copolymer in which one polymer block (A1) and one polymer block (A2) are bonded.

The mass ratio of the polymerizable monomer (a1) to the polymerizable monomer (a2) in the polymerizable component of the copolymer of the present invention is, for example, polymerizable monomer (a1):polymerizable monomer (a2) = 5:95 to 95:5, preferably polymerizable monomer (a1):polymerizable monomer (a2) = 20:80 to 90:10, more preferably polymerizable monomer (a1):polymerizable monomer (a2) = 30:70 to 80:20, and even more preferably polymerizable monomer (a1):polymerizable monomer (a2) = 50:50 to 80:20.

As long as the copolymer of the present invention is a copolymer containing a polymerizable monomer (a1) and a polymerizable monomer (a2) as polymerizable components, an additional polymerizable monomer other than the polymerizable monomer (a1) and the polymerizable monomer (a2) may be contained as a polymerizable component to the extent that the effect of the present invention is not compromised.
The copolymer of the present invention is preferably a copolymer substantially composed of the polymerizable monomer (a1) and the polymerizable monomer (a2), and more preferably a copolymer composed only of the polymerizable monomer (a1) and the polymerizable monomer (a2). The wording "substantially composed of" as used herein means that the percentage of the total content of the polymerizable monomer (a1) and the polymerizable monomer (a2) is 80 mass% or more, 90 mass% or more, 95 mass% or more, or 99 mass% or more, in the polymerizable component of the copolymer of the present invention.

In the copolymer of the present invention, 50 mass% or more of the polymerizable component other than the polymerizable monomer (a1) is preferably a monomer whose polymerizable unsaturated group is an acryloyl group.
The polymerizable component other than the polymerizable monomer (a1) is more preferred when a proportion of the monomer whose polymerizable unsaturated group is an acryloyl group is higher, for example, 70 mass%, 80 mass% or more, 90 mass% or more, 95 mass% or more, and 100 mass%.

The copolymer of the present invention preferably contains no fluorine atom.
For example, when the copolymer of the present invention is composed of the polymerizable monomer (a1) and the polymerizable monomer (a2), the copolymer of the present invention is a copolymer containing no fluorine atom.

The number average molecular weight (Mn) of the copolymer of the present invention is preferably in a range of from 1000 to 500000, more preferably in a range of from 2000 to 100000, and even more preferably in a range of from 2000 to 40000.
The weight average molecular weight (Mw) of the copolymer of the present invention is, for example, in a range of from 1000 to 500000, preferably in a range of from 2000 to 100000, more preferably in a range of from 2000 to 40000, and even more preferably in a range of from 12000 to 40000.
The degree of dispersion (Mw/Mn) of the copolymer of the present invention is preferably in a range of from 1.0 to 2.0, more preferably in a range of from 1.0 to 1.8, and even more preferably in a range of from 1.0 to 1.5.

In the present invention, the weight average molecular weight (Mw) and the number average molecular weight (Mn) are values based on gel permeation chromatography (GPC) measurement calibrated with polystyrene standards. The values of the number average molecular weight (Mn) and the weight average molecular weight (Mw) of the copolymer of the present invention are measured by the method described in Examples.

### Method for Producing Copolymer

The method for producing the copolymer of the present invention is not particularly limited, and the copolymer can be produced by a known method.

The copolymer of the present invention can be produced by a solution polymerization method, a bulk polymerization method, an emulsion polymerization method, or the like based on a polymerization mechanism such as a radical polymerization process, a cationic polymerization process, or an anionic polymerization process. For example, in a case of a radical polymerization method, a polymerizable monomer mixture is fed into an organic solvent, then a general-purpose radical polymerization initiator is added thereto, and thus the copolymer of the present invention can be produced.

As the polymerization initiator, various polymerization initiators can be used, and examples thereof include: peroxides such as t-butylperoxy-2-ethylhexanoate, benzoyl peroxide, and diacyl peroxide; azo compounds such as azobisisobutyronitrile, dimethyl azobisisobutyrate, and phenylazotriphenylmethane; and metal chelate compounds such as Mn(acac)₃. If necessary, a chain transfer agent such as lauryl mercaptan, 2-mercaptoethanol, ethylthioglycolic acid, or octylthioglycolic acid, or a thiol compound having a coupling group such as γ-mercaptopropyltrimethoxysilane may be used as an additive such as a chain transfer agent.

Examples of the organic solvent include: alcohols such as ethanol, isopropyl alcohol, n-butanol, iso-butanol, and tert-butanol; ketones such as acetone, methyl ethyl ketone, methyl isobutyl ketone, and methyl amyl ketone; esters such as methyl acetate, ethyl acetate, butyl acetate, methyl lactate, ethyl lactate, and butyl lactate; monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate; polar solvents such as dimethylformamide, dimethyl sulfoxide, and N-methylpyrrolidone; ethers such as methyl cellosolve, cellosolve, butyl cellosolve, butyl carbitol, and ethyl cellosolve acetate; propylene glycols such as propylene glycol, propylene glycol monomethyl ether, and propylene glycol monomethyl ether acetate, propylene glycol monoethyl ether acetate and propylene glycol monobutyl ether acetate, and esters thereof; halogen-based solvents such as 1,1,1-trichloroethane and chloroform; ethers such as tetrahydrofuran and dioxane; aromatics such as benzene, toluene and xylene; and fluorinated inert liquids such as perfluorooctane and perfluorotri-n-butylamine.
These solvents may be used singly, or two or more types thereof may be used in combination.

The copolymer of the present invention is preferably produced by subjecting the polymerizable component containing the polymerizable monomer (a1) and the polymerizable monomer (a2) to living polymerization, such as living radical polymerization or living anionic polymerization.

In the living radical polymerization, a dormant species whose active polymerization terminal is protected by an atom or an atomic group reversibly generates a radical and reacts with a monomer, thereby a growth reaction proceeds, and the growth terminal does not lose activity even when the first monomer is consumed, and can react with a second monomer added sequentially and thereby affording a block polymer. Examples of such living radical polymerization include atom transfer radical polymerization (ATRP), reversible addition-fragmentation chain transfer polymerization (RAFT), nitroxide-mediated radical polymerization (NMP), and organotelluriummediated radical polymerization (TERP). Among these methods, there is no particular restriction on which method to be used, but ATRP is preferable in terms of ease of control and the like. ATRP is a process that involves polymerization in which an organic halide, a sulfonyl halide compound, or the like is used as a polymerization initiator and a metal complex composed of a transition metal compound and a ligand is used as a catalyst.

Specific examples of the polymerization initiator that can be used in ATRP include 1-phenylethyl chloride, 1-phenylethyl bromide, chloroform, carbon tetrachloride, 2-chloropropionitrile, α,α'-dichloroxylene, α,α'-dibromoxylene, hexakis(α-bromomethyl)benzene, and alkyl esters having from 1 to 6 carbon atoms of 2-halogenated carboxylic acids having from 1 to 6 carbon atoms (such as 2-chloropropionic acid, 2-bromopropionic acid, 2-chloroisobutyric acid, 2-bromoisobutyric acid, etc.).
More specific examples of the alkyl ester having from 1 to 6 carbon atoms of 2-halogenated carboxylic acid having from 1 to 6 carbon atoms include methyl 2-chloropropionate, ethyl 2-chloropropionate, methyl 2-bromopropionate, and ethyl 2-bromoisobutyrate.

The transition metal compound that can be used in ATRP is represented by Mⁿ⁺Xₙ.
The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺, Mo²⁺, Mo³⁺, W²⁺, W³⁺, Rh³⁺, Rh⁴⁺, Co⁺, Co²⁺, Re²⁺, Re³⁺, Ni⁰, Ni⁺, Mn³⁺, Mn⁴⁺, V²⁺, V³⁺, Zn⁺, Zn²⁺, Au⁺, Au²⁺, Ag⁺, and Ag²⁺.
X of the transition metal compound represented by Mⁿ⁺Xₙ can be selected from the group consisting of a halogen atom, an alkoxyl group having from 1 to 6 carbon atoms, (SO₄)_{1/2}, (PO₄)_{1/3}, (HPO₄)_{1/2}, (H₂PO₄), triflate, hexafluorophosphate, methanesulfonate, aryl sulfonate (preferably benzenesulfonate or toluenesulfonate), SeR¹¹, CN and R¹²COO. Here, R¹¹ represents an aryl group, a linear or branched alkyl group having from 1 to 20 carbon atoms (preferably from 1 to 10 carbon atoms), and R¹² represents a hydrogen atom, or a linear or branched alkyl group having from 1 to 6 carbon atoms (preferably a methyl group) which may be substituted with halogen for 1 to 5 times (preferably with fluorine or chlorine for 1 to 3 times). n of the transition metal compound represented by Mⁿ⁺Xₙ represents a formal charge on the metal, and is an integer of from 0 to 7.

Examples of a ligand compound capable of coordinate-bonding to the transition metal of the above-mentioned transition metal compound include: a compound having a ligand containing one or more nitrogen atoms, oxygen atoms, phosphorus atoms, or sulfur atoms that are capable of coordinating to the transition metal via a σ bond; a compound having a ligand containing two or more carbon atoms that are capable of coordinating to the transition metal via a π bond; and a compound having a ligand that is capable of coordinating to the transition metal via a µ bond or an η bond.

The above-mentioned transition metal complex is not particularly limited, and preferred examples thereof include transition metal complexes of Groups 7, 8, 9, 10, and 11, and further preferred examples thereof include complexes of zerovalent copper, monovalent copper, divalent ruthenium, divalent iron, or divalent nickel.

Specific examples of the catalyst that can be used in ATRP, when the central metal is copper, include complexes with ligands such as 2,2'-bipyridyl and derivatives thereof, 1,10-phenanthroline and derivatives thereof, and polyamines such as tetramethylethylenediamine, pentamethyldiethylenetriamine, and hexamethyltris(2-aminoethyl)amine. Examples of the divalent ruthenium complex include dichlorotris(triphenylphosphine)ruthenium, dichlorotris(tributylphosphine)ruthenium, dichloro(cyclooctadiene)ruthenium, dichloro(benzene)ruthenium, dichloro(p-cymene)ruthenium, dichloro(norbornadiene)ruthenium, cis-dichlorobis(2,2'-bipyridine)ruthenium, dichlorotris(1,10-phenanthroline)ruthenium, and carbonylchlorohydridetris(triphenylphosphine)ruthenium. Furthermore, examples of the divalent iron complex include bis(triphenylphosphine) complexes and triazacyclononane complexes.

A solvent is preferably used in living radical polymerization.
Examples of the solvent used in living radical polymerization include: ester solvents such as ethyl acetate, butyl acetate, and propylene glycol monomethyl ether acetate; ether solvent such as diisopropyl ether, dimethoxyethane, and diethylene glycol dimethyl ether; halogen-based solvents such as dichloromethane and dichloroethane; aromatic solvents such as toluene and xylene; ketone solvents such as methyl ethyl ketone, methyl isobutyl ketone, and cyclohexanone; alcohol solvents such as methanol, ethanol, or isopropanol; aprotic polar solvents such as dimethylformamide and dimethylsulfoxide.
The above-mentioned solvents may be used singly, or two or more types thereof may be used in combination.

The copolymer of the present invention can be produced by, for example, any one of the following methods 1 to 3.
Method 1: A method of subjecting a polymerizable monomer (a1) and a polymerizable monomer (a2) to living radical polymerization (preferably atom transfer radical polymerization) in the presence of a polymerization initiator, a transition metal compound, a ligand compound capable of coordinate-bonding to the transition metal, and a solvent.
Method 2: A method of subjecting a polymerizable monomer (a1) to living radical polymerization (preferably atom transfer radical polymerization) in the presence of a polymerization initiator, a transition metal compound, a ligand compound capable of coordinate-bonding to the transition metal, and a solvent to obtain a polymer block (A1), and then a polymerizable monomer (a2) is added to the reaction system to further perform living radical polymerization (preferably atom transfer radical polymerization) of the polymerizable monomer (a2) and the polymer block (A1).
Method 3: A method of subjecting a polymerizable monomer (a2) to living radical polymerization (preferably atom transfer radical polymerization) in the presence of a polymerization initiator, a transition metal compound, a ligand compound capable of coordinate-bonding to the transition metal, and a solvent to obtain a polymer block (A2), and then a polymerizable monomer (a1) is added to the reaction system to further perform living radical polymerization (preferably atom transfer radical polymerization) of the polymerizable monomer (a1) and the polymer block (A2).

The feed ratio (mass) between the polymerizable monomer (a1) and the polymerizable monomer (a2) in producing the copolymer of the present invention is, for example, polymerizable monomer (a1):polymerizable monomer (a2) = 5:95 to 95:5, preferably polymerizable monomer (a1):polymerizable monomer (a2) = 20:80 to 90:10, more preferably polymerizable monomer (a1):polymerizable monomer (a2) = 30:70 to 80:20, and even more preferably polymerizable monomer (a1):polymerizable monomer (a2) = 50:50 to 80:20.

The polymerization temperature in the living radical polymerization is preferably in a range of from room temperature to 120°C.

When the copolymer of the present invention is produced by living radical polymerization, there may be a case where a metal derived from the transition metal compound used in the polymerization remains in the resulting copolymer. After completion of the polymerization, the metal remaining in the resulting copolymer is preferably removed by using active alumina or the like.

### Coating Composition

The copolymer of the present invention can be suitably used as a leveling agent for a coating composition, and the coating composition of the present invention contains the copolymer of the present invention. The copolymer of the present invention can be used as a fluorine atom-free leveling agent that contains no fluorine atom, and hence is a leveling agent with low environmental impact and low accumulation in the environment.

The copolymer content of the present invention contained in the coating composition of the present invention varies depending on the type of base resin, the coating method, the intended film thickness, and the like, but is, for example, in a range of from 0.0001 to 10 parts by mass, preferably in a range of from 0.0001 to 5 parts by mass, more preferably in a range of from 0.0001 to 1 part by mass, and even more preferably in a range of from 0.0001 to 0.05 parts by mass, per 100 parts by mass of the solids content of the coating composition.
Even a small amount of the copolymer of the present invention can achieve the leveling effect.
Note that the expression "solids content of a coating composition" refers to a component contained in the coating composition other than water and solvent(s).

The intended use of the coating composition of the present invention is not particularly limited, and the coating composition can be used in any intended use where leveling properties are required. The coating composition of the present invention can be used as, for example, various coating compositions and photosensitive resin compositions.

When the coating composition of the present invention is used as a composition for a coating material, examples of the composition for a coating material include: coating materials using a natural resin, such as a petroleum resin coating material, a shellac coating material, a rosin-based coating material, a cellulose-based coating material, a rubber-based coating material, an urushi lacquer coating material, a cashew lacquer coating material, and an oil-based vehicle coating material; and coating materials using a synthetic resin, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, a silicone resin coating material, and a fluororesin coating material.
The copolymer of the present invention is added to the above-mentioned composition for a coating material, and thus smoothness can be imparted to the resulting coating film.

Into the composition for a coating material can be appropriately added various additives if needed, and examples thereof include: colorants such as pigments, dyes, and carbon; inorganic powders such as silica, titanium oxide, zinc oxide, aluminum oxide, zirconium oxide, calcium oxide, and calcium carbonate; organic fine powders such as higher fatty acids, polyacrylic resins, and polyethylene; light resistance improvers, weather resistance improvers, heat resistance improvers, antioxidants, thickeners, and anti-settling agents.

As a method for applying the coating composition of the present invention, any publicly known and used coating method can be used, and examples thereof include methods, such as slit coater, slit and spin coater, spin coater, roll coater, electrostatic coating, bar coater, gravure coater, die coater, knife coater, inkjet, dipping coating, spray coating, shower coating, screen printing, gravure printing, offset printing, and reverse coating.

The photosensitive resin composition is a composition in which the resin changes its physical properties such as solubility, viscosity, transparency, refractive index, conductivity, and ion permeability upon irradiation with light such as visible light and ultraviolet light.
Among photosensitive resin compositions, a resist composition (such as a photoresist composition and a color resist composition for a color filter) is required to have high leveling properties. The resist composition is usually applied by spin coating so as to have a thickness of about from 1 to 2 µm onto a silicon wafer or a glass substrate on which various metals are vapor-deposited. During this application, if the applied film thickness fluctuates or heterogeneity in application occurs, the linearity and reproducibility of patterns deteriorate, and a resist pattern having intended accuracy cannot be provided. Moreover, besides these issues, there are also various issues related to leveling, such as a drop mark, overall heterogeneity, and a bead phenomenon in which the applied film on the edge area has a larger thickness than on the central area.
The copolymer of the present invention exhibits high leveling properties and can form a uniform coating film (a cured product), and therefore the above-mentioned issues can be solved when the coating composition of the present invention is used as a resist composition.

When the coating composition of the present invention is used as a photoresist composition, the photoresist composition contains an alkali-soluble resin, a radiation-sensitive substance (photosensitive substance), a solvent and the like, besides the copolymer of the present invention.

The alkali-soluble resin contained in the photoresist composition is a resin soluble in an alkaline solution that is a developer used when a resist is patterned. Examples of the alkali-soluble resin include: novolak resins produced by condensing an aromatic hydroxy compound derivative such as phenol, cresol, xylenol, resorcinol, phloroglucinol or hydroquinone with an aldehyde compound such as formaldehyde, acetaldehyde or benzaldehyde; polymers or copolymers of vinylphenol compound derivatives such as o-vinylphenol, m-vinylphenol, p-vinylphenol or α-methylvinylphenol; (meth)acrylic polymers or copolymers such as acrylic acid, methacrylic acid or hydroxyethyl (meth)acrylate; polyvinyl alcohol; modified resins having a radiation-sensitive group such as a quinone diazide group, a naphthoquinone azide group, an aromatic azide group or an aromatic cinnamoyl group introduced via some of hydroxyl groups of these various resins; and urethane resins containing an acidic group such as a carboxylic acid or a sulfonic acid in the molecule. These alkali-soluble resins may be used singly, or two or more types thereof may be used in combination.

In a case where the coating composition of the present invention is used as a photoresist composition, the content of the copolymer of the present invention is, for example, 0.05 parts by mass or less, and preferably in a range of from 0.0001 to 0.05 parts by mass, per 100 parts by mass of the alkali-soluble resin.

The radiation-sensitive substance contained in the photoresist composition is a substance that changes the solubility of the alkali-soluble resin with respect to a developer upon irradiation with energy rays such as ultraviolet rays, far ultraviolet rays, excimer laser beams, X-rays, electron beams, ion beams, molecular beams, and γ-rays.
Examples of the radiation-sensitive substance include quinone diazide compounds, diazo compounds, azide compounds, onium salt compounds, halogenated organic compounds, mixtures of halogenated organic compounds and organometallic compounds, organic acid ester compounds, organic acid amide compounds, organic acid imide compounds, and poly(olefin sulfone) compounds.

Examples of the quinone diazide compound include sulfonic acid chlorides of quinone diazide derivatives such as 1,2-benzoquinone azide-4-sulfonic acid ester, 1,2-naphthoquinone diazide-4-sulfonic acid ester, 1,2-naphthoquinone diazide-5-sulfonic acid ester, 2,1-naphthoquinone diazide-4-sulfonic acid ester, 2,1-naphthoquinone diazide-5-sulfonic acid ester, other 1,2-benzoquinone azide-4-sulfonic acid chloride, 1,2-naphthoquinone diazide-4-sulfonic acid chloride, 1,2-naphthoquinone diazide-5-sulfonic acid chloride, 2,1-naphthoquinone diazide-4-sulfonic acid chloride, and 2,1-naphthoquinone diazide-5-sulfonic acid chloride.

Examples of the diazo compound include: salts of condensation products of p-diazodiphenylamine with formaldehyde or acetaldehyde; inorganic salts of diazoresins that are reaction products of the above-mentioned condensation products with hexafluorophosphate, tetrafluoroborate, perchlorate or periodate; and organic salts of diazoresins that are reaction products of the above-mentioned condensation products with sulfonic acids as described in US Patent 3,300,309.

Examples of the azide compound include azidochalconic acid, diazidobenzalmethylcyclohexanones, azidocinnamylidene-acetophenones, aromatic azide compounds, and aromatic diazide compounds.

Examples of the halogenated organic compound include halogen-containing oxadiazole compounds, halogen-containing triazine compounds, halogen-containing acetophenone compounds, halogen-containing benzophenone compounds, halogen-containing sulfoxide compounds, halogen-containing sulfone compounds, halogen-containing thiazole compounds, halogen-containing oxazole compounds, halogen-containing triazole compounds, halogen-containing 2-pyrone compounds, halogen-containing aliphatic hydrocarbon compounds, halogen-containing aromatic hydrocarbon compounds, halogen-containing heterocyclic compounds, and sulfenyl halide compounds.
Besides the above-mentioned compounds, examples of the halogenated organic compounds include: compounds used as halogen-based flame retardants such as tris(2,3-dibromopropyl)phosphate, tris(2,3-dibromo-3-chloropropyl)phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis (4-hydroxy-3,5-dibromophenyl) propane, and 2,2-bis(4-hydroxyethoxy-3,5-dibromophenyl) propane; and compounds used as organic chloro-based agricultural chemicals such as dichlorophenyltrichloroethane.

Examples of the organic acid ester include carboxylic acid esters and sulfonic acid esters. Examples of the organic acid amide include carboxylic acid amides and sulfonic acid amides. Examples of the organic acid imide include carboxylic acid imides and sulfonic acid imides.
The radiation-sensitive substances may be used singly, or two or more types thereof may be used in combination.

In the photoresist composition, the content of the radiation-sensitive substance is preferably in a range of from 10 to 200 parts by mass, and more preferably in a range of from 50 to 150 parts by mass per 100 parts by mass of the alkali-soluble resin.

Examples of the solvent for the photoresist composition include: ketones such as acetone, methyl ethyl ketone, cyclohexanone, cyclopentanone, cycloheptanone, 2-heptanone, methyl isobutyl ketone, and butyrolactone; alcohols such as methanol, ethanol, n-propyl alcohol, iso-propyl alcohol, n-butyl alcohol, iso-butyl alcohol, tert-butyl alcohol, pentanol, heptanol, octanol, nonanol, and decanol; ethers such as ethylene glycol dimethyl ether, ethylene glycol diethyl ether and dioxane; alcohol ethers such as ethylene glycol monomethyl ether, ethylene glycol monoethyl ether, ethylene glycol monopropyl ether, propylene glycol monomethyl ether, propylene glycol monoethyl ether and propylene glycol monopropyl ether; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, and butyl lactate; and monocarboxylic acid esters such as methyl 2-oxypropionate, ethyl 2-oxypropionate, propyl 2-oxypropionate, butyl 2-methoxypropionate, methyl 2-methoxypropionate, ethyl 2-methoxypropionate, propyl 2-methoxypropionate, and butyl 2-methoxypropionate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether acetate; diethylene glycols such as diethylene glycol monomethyl ether, diethylene glycol monoethyl ether, diethylene glycol dimethyl ether, diethylene glycol diethyl ether and diethylene glycol methyl ethyl ether; halogenated hydrocarbons such as trichloroethylene, chlorofluorocarbon solvent, HCFC, and HFC; completely fluorinated solvents such as perfluorooctane, aromatics such as toluene and xylene; and polar solvents such as dimethylacetamide, dimethylformamide, N-methylacetamide, and N-methylpyrrolidone.
These solvents may be used singly, or two or more types thereof may be used in combination.

When the coating composition of the present invention is used as a color resist composition, the color resist composition contains an alkali-soluble resin, a polymerizable compound, a colorant, and the like, besides the copolymer of the present invention.

As the alkali-soluble resin contained in color resists, the same alkali-soluble resin as the alkali-soluble resin contained in the photoresist composition described above can be used.

The polymerizable compound contained in the color resist composition is, for example, a compound having a photopolymerizable functional group capable of undergoing polymerization or crosslinking reaction upon irradiation with active energy rays such as ultraviolet rays.
Examples of the above-mentioned polymerizable compound include: unsaturated carboxylic acids such as (meth)acrylic acid; esters of a monohydroxy compound and an unsaturated carboxylic acid; esters of an aliphatic polyhydroxy compound and an unsaturated carboxylic acid; esters of an aromatic polyhydroxy compound and an unsaturated carboxylic acid; esters produced by an esterification reaction of an unsaturated carboxylic acid with a polyhydric carboxylic acid and a polyhydroxy compound such as the aliphatic polyhydroxy compound described above or an aromatic polyhydroxy compound; polymerizable compounds having a urethane skeleton produced by reacting a polyisocyanate compound with a (meth)acryloyl group-containing hydroxy compound; and polymerizable compounds having an acid group.
The polymerizable compounds may be used singly, or two or more types thereof may be used in combination.

Examples of the ester of an aliphatic polyhydroxy compound and an unsaturated carboxylic acid include (meth)acrylic acid esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, and glycerol (meth)acrylate.
Examples thereof also include esters in which the (meth)acrylic acid moiety of these acrylates is changed to itaconic acid, crotonic acid, and maleic acid, those are itaconic acid esters, crotonic acid esters, and maleic acid esters, respectively.

Examples of the ester of an aromatic polyhydroxy compound and an unsaturated carboxylic acid include hydroquinone di(meth)acrylate, resorcinol di(meth)acrylate, and pyrogallol tri(meth)acrylate.
The ester produced by esterification reaction of an unsaturated carboxylic acid, a polyhydric carboxylic acid, and a polyhydroxy compound may be a single compound or a mixture. Examples of such esters include: esters produced from (meth)acrylic acid, phthalic acid, and ethylene glycol; esters produced from (meth)acrylic acid, maleic acid, and diethylene glycol; esters produced from (meth)acrylic acid, terephthalic acid, and pentaerythritol; and esters produced from (meth)acrylic acid, adipic acid, butanediol, and glycerin.

Examples of the polymerizable compound having a urethane skeleton produced by reacting the polyisocyanate compound with a (meth)acryloyl group-containing hydroxy compound include: aliphatic diisocyanates such as hexamethylene diisocyanate and trimethylhexamethylene diisocyanate; cycloaliphatic diisocyanate such as cyclohexane diisocyanate and isophorone diisocyanate; and reaction products of an aromatic diisocyanate such as tolylene diisocyanate or diphenylmethane diisocyanate with a hydroxy compound having a (meth)acryloyl group such as 2-hydroxyethyl (meth)acrylate or 3-hydroxy[1,1,1-tri(meth)acryloyloxymethyl]propane.

The polymerizable compound having an acid group is, for example, an ester of an aliphatic polyhydroxy compound and an unsaturated carboxylic acid, and is preferably a polyfunctional polymerizable compound having an acid group produced by reacting an unreacted hydroxyl group of an aliphatic polyhydroxy compound with a non-aromatic carboxylic acid anhydride. The aliphatic polyhydroxy compound used in the preparation of the polyfunctional polymerizable compound is preferably pentaerythritol or dipentaerythritol.
In terms of improvement of developability, curability, and the like, the polyfunctional polymerizable compound has an acid value preferably in the range of from 0.1 to 40, and more preferably in the range of from 5 to 30. When two or more polyfunctional polymerizable compounds having an acid group are used in combination, or when a polyfunctional polymerizable compound having an acid group and a polyfunctional polymerizable compound having no acid group are used in combination, the mixture of the polymerizable compounds is preferably adjusted to have an acid value within the range mentioned above.

As a specific example of the polymerizable compound having an acid group, mention may be made of a mixture whose main components are succinic ester of dipentaerythritol pentaacrylate, dipentaerythritol hexaacrylate, and dipentaerythritol pentaacrylate, and this mixture is commercially available as ARONIX TO-1382 (available from TOAGOSEI CO., LTD.).

Besides the above-mentioned compounds, examples of polymerizable compounds include: (meth)acrylamides such as ethylenebis(meth)acrylamide; allyl esters such as diallyl phthalate; and compounds having a vinyl group such as divinyl phthalate.

In the color resist composition, the content of the polymerizable compound is preferably in the range of from 5 to 80 mass%, more preferably in the range of from 10 to 70 mass%, and still more preferably in the range of from 20 to 50 mass%, of the total solids content of the color resist composition.

The colorant of the color resist composition is not particularly limited as long as it is capable of coloring, and may be, for example, a pigment or a dye.
As the pigment, either an organic pigment or an inorganic pigment may be used. As the organic pigment, there can be used pigments of various hues such as a red pigment, a green pigment, a blue pigment, a yellow pigment, a purple pigment, an orange pigment, and a brown pigment. Moreover, examples of the chemical structure of the organic pigment include azo type, phthalocyanine type, quinacridone type, benzimidazolone type, isoindolinone type, dioxazine type, indanthrene type, and perylene type. Furthermore, examples of the inorganic pigment include barium sulfate, lead sulfate, titanium oxide, yellow lead, red iron oxide, and chromium oxide.
Note that the following "C.I." means a color index.

Examples of the red pigment include C.I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, 276, and the like. Among them, C.I. Pigment Red 48:1, 122, 168, 177, 202, 206, 207, 209, 224, 242, or 254 is preferable, and C.I. Pigment Red 177, 209, 224, or 254 is more preferable.

Examples of the green pigment include C.I. Pigment Green 1, 2, 4, 7, 8, 10, 13, 14, 15, 17, 18, 19, 26, 36, 45, 48, 50, 51, 54, 55, and 58. Among them, C.I. Pigment Green 7, 36 or 58 is preferable.

Examples of the blue pigment include C.I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79. Among them, C.I. Pigment Blue 15, 15:1, 15:2, 15:3, 15:4, or 15:6 is preferable, and C.I. Pigment Blue 15:6 is more preferable.

Examples of the yellow pigment include C.I. Pigment Yellow 1, 1:1, 2, 3, 4, 5, 6, 9, 10, 12, 13, 14, 16, 17, 24, 31,32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208. Among them, C.I. Pigment Yellow 83, 117, 129, 138, 139, 150, 154, 155, 180, or 185 is preferable, and C.I. Pigment Yellow 83, 138, 139, 150, or 180 is more preferable.

Examples of the purple pigment include C.I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, and 50. Among them, C.I. Pigment Violet 19 or 23 is preferable, and C.I. Pigment Violet 23 is more preferable.

Examples of the orange pigment include C.I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among them, C.I. Pigment Orange 38 or 71 is preferable.

Since each pixel of color filters used in liquid crystal display devices and in organic EL display devices has the three primary colors of red (R), green (G), and blue (B), the red pigment, the green pigment, and the blue pigment are used as main components, and organic pigments of colors such as yellow, purple, and orange may be used as hue adjustment for the purpose of improving color reproducibility.

The average particle size of the organic pigment is preferably 1 µm or less, more preferably 0.5 µm or less, still more preferably 0.3 µm or less in order to increase the luminance of color liquid crystal display devices and organic EL display devices. The organic pigments are preferably used after dispersion treatment so as to have such an average particle size.
The average primary particle size of the organic pigments is preferably 100 nm or less, more preferably 50 nm or less, still more preferably 40 nm or less, and particularly preferably in the range of from 10 to 30 nm.
Note that, the average particle size of the organic pigments is measured by a dynamic light scattering type particle size analyzer, and can be measured by, for example, Nanotrac particle size analyzer "UPA-EX150" or "UPA-EX250" available from NIKKISO CO., LTD.

The colorant when the color resist composition is used for forming the black matrix (BM) is not particularly limited as long as it is black in color, and examples thereof include carbon black, lamp black, acetylene black, bone black, thermal black, channel black, furnace black, graphite, black iron oxide, and titanium black. Among them, carbon black and titanium black are preferable in terms of light shielding ratios and image characteristics.
Alternatively, there may be used a combination of two or more types of organic pigments mixed to create black by color mixing.

Examples of commercially available products of the carbon black include: MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, OIL31B, etc., which are available from Mitsubishi Chemical Corporation; Printex3, Printex3OP, Printex30, Printex30OP, Printex40, Printex45, Printex55, Printex60, Printex75, Printex80, Printex85, Printex90, Printex A, Printex L, Printex G, Printex P, Printex U, Printex V, Printex G, SpecialBlack550, SpecialBlack350, SpecialBlack250, SpecialBlack100, SpecialBlack6, SpecialBlack5, SpecialBlack4, Color Black FW1, Color Black FW2, Color Black FW2V, Color Black FW18, Color Black FW18, Color Black FW200, Color Black S160, Color Black S170, etc., which are available from Evonik Degussa Japan Ltd; Monarch120, Monarch280, Monarch460, Monarch800, Monarch880, Monarch900, Monarch1000, Monarch1100, Monarch1300, Monarch1400, Monarch4630, REGAL99, REGAL99R, REGAL415, REGAL415R, REGAL250, REGAL250R, REGAL330, REGAL400R, REGAL55R0, REGAL660R, BLACK PEARLS480, PEARLS130, VULCAN XC72R, ELFTEX-8, etc., which are available from Cabot Japan K.K; and RAVEN11, RAVEN14, RAVEN15, RAVEN16, RAVEN22 RAVEN30, RAVEN35, RAVEN40, RAVEN410, RAVEN420, RAVEN450, RAVEN500, RAVEN780, RAVEN850, RAVEN890H, RAVEN1000, RAVEN1020, RAVEN1040, RAVEN1060U, RAVEN1080U, RAVEN1170, RAVEN1190U, RAVEN1250, RAVEN1500, RAVEN2000, RAVEN2500U, RAVEN3500, RAVEN5000, RAVEN5250, RAVEN5750, RAVEN7000, etc., which are available from Columbian Carbon Company.

Among the above-mentioned carbon blacks, resin-coated carbon black is preferable as a carbon black having high optical density and high surface resistivity required for a black matrix of a color filter.

Examples of commercially available products of the titanium black include titanium black 10S, 12S, 13R, 13M, and 13M-C available from Mitsubishi Materials Corporation.

As a colorant used for forming the black matrix (BM), two or more types of organic pigments may be mixed to create black color by color mixing, and examples thereof include a black pigment produced by mixing pigments of three colors of red, green, and blue.
Examples of the coloring material that can be mixed and used for preparing the black pigment include Victoria Pure Blue (C.I. 42595), Auramine O (C.I. 41000), Cationic Brilliant Flavin (Basic 13), Rhodamine 6GCP (C.I. 45160), Rhodamine B (C.I. 45170), Safranin OK70:100 (C.I. 50240), Erioglaucin X (C.I. 42080), No. 120/Lionol Yellow (C.I. 21090), Lionol Yellow GRO (C.I. 21090), Symuler Fast Yellow 8GF (C.I. 21105), Benzidine Yellow 4T-564D (C.I. 21095), Symuler Fast Red 4015 (C.I. 12355), Lionol Red 7B4401 (C.I. 15850), Fastogen Blue TGR-L (C.I. 74160), Lionol Blue SM (C.I. 26150), Lionol Blue ES (C. I. Pigment Blue 15:6), Lionogen Red GD (C.I. Pigment Red 168), and Lionol Green 2YS (C.I. Pigment Green 36).

Examples of other coloring materials that can be mixed and used to prepare the black pigment include: C.I. Pigment Yellow 20, 24, 86, 93, 109, 110, 117, 125, 137, 138, 147, 148, 153, 154, and 166; C.I. Pigment Orange 36, 43, 51, 55, 59, and 61; C.I. Pigment Red 9, 97, 122, 123, 149, 168, 177, 180, 192, 215, 216, 217, 220, 223, 224, 226, 227, 228, and 240; C.I. Pigment Violet 19, 23, 29, 30, 37, 40, and 50; C.I. Pigment Blue 15, 15:1, 15:4, 22, 60, and 64; C.I. Pigment Green 7; and C.I. Pigment Brown 23, 25, and 26.

When carbon black is used as the black pigment, the average primary particle size of the carbon black is preferably in the range of from 0.01 to 0.08 µm, and more preferably in the range of from 0.02 to 0.05 µm in terms of excellent developability.

The particle shape of carbon black is different from that of organic pigments or the like, and carbon black is present in a state called a structure in which primary particles are fused to each other, and fine pores are formed on the particle surface by post-treatment in some cases. Therefore, generally, in order to represent the particle shape of carbon black, besides the average particle size of primary particles determined by the same method as that of the organic pigment, the DBP absorption number (JIS K6221) and the specific surface area (JIS K6217) by the BET method are preferably measured and used as indices of the structure and of the pore amount.
The amount of dibutylphthalic acid (hereinafter, abbreviated as "DBP") absorbed by carbon black is preferably in the range of from 40 to 100 cm³/100 g, and more preferably in the range of from 50 to 80 cm³/100 g in terms of excellent dispersibility and developability. The specific surface area of carbon black measured by the BET method is preferably in the range of from 50 to 120 m²/g, and more preferably in the range of from 60 to 95 m²/g in terms of excellent dispersion stability.

Examples of the dye as the colorant for the color resist composition include azo dyes, anthraquinone dyes, phthalocyanine dyes, quinoneimine dyes, quinoline dyes, nitro dyes, carbonyl dyes, and methine dyes.

Examples of the azo dyes include C.I. Acid Yellow 11, C.I. Acid Orange 7, C.I. Acid Red 37, C.I. Acid Red 180, C.I. Acid Blue 29, C.I. Direct Red 28, C.I. Direct Red 83, C.I. Direct Yellow 12, C.I. Direct Orange 26, C.I. Direct Green 28, C.I. Direct Green 59, C.I. Reactive Yellow 2, C.I. Reactive Red 17, C.I. Reactive Red 120, C.I. Reactive Black 5, C.I. Disperse Orange 5, C.I. Disperse Red 58, C.I. Disperse Blue 165, C.I. Basic Blue 41, C.I. Basic Red 18, C.I. Mordant Red 7, C.I. Mordant Yellow 5, C.I. and Mordant Black 7.

Examples of the anthraquinone dye include C.I. Vat Blue 4, C.I. Acid Blue 40, C.I. Acid Green 25, C.I. Reactive Blue 19, C.I. Reactive Blue 49, C.I. Disperse Red 60, C.I. Disperse Blue 56, and C.I. Disperse Blue 60.

Examples of the phthalocyanine dye include C.I. Pad Blue 5, examples of the quinoneimine dye include C.I. Basic Blue 3 and C.I. Basic Blue 9, examples of the quinoline dye include C.I. Solvent Yellow 33, C.I. Acid Yellow 3, and C.I. Disperse Yellow 64, and examples of the nitro dye include C.I. Acid Yellow 1, C.I. Acid Orange 3, and C.I. Disperse Yellow 42.

As the colorant of the color resist composition, a pigment is preferably used in terms that the resulting coating film is excellent in light resistance, weather resistance, and fastness properties, but a dye may be used in combination with the pigment as necessary in order to adjust the hue.

In the color resist composition, the content of the colorant is preferably 1 mass% or more, more preferably in the range of from 5 to 80 mass%, and still more preferably in the range of from 5 to 70 mass% of the total solids content of the color resist composition.

When the color resist composition is used for forming each pixel of red (R), green (G), and blue (B) of a color filter, the content of the colorant in the color resist composition is preferably in the range of from 5 to 60 mass%, and more preferably in the range of from 10 to 50 mass% of the total solids content of the color resist composition.

When the color resist composition is used for forming a black matrix of a color filter, the content of the colorant in the color resist composition is preferably in the range of from 20 to 80 mass%, and more preferably in the range of from 30 to 70 mass% of the total solids content of the color resist composition.

When the pigment is used as a colorant in the color resist composition, the pigment is preferably used as a pigment dispersion liquid that is prepared by using a dispersant and thereby dispersing the pigment in an organic solvent. Examples of the dispersant include: surfactants; pigment intermediates or derivatives; dyestuff intermediates or derivatives; and resin-type dispersants such as polyamide resins, polyurethane resins, polyester resins, and acrylic resins. Among them, graft copolymers having a nitrogen atom, acrylic block copolymers having a nitrogen atom, urethane resin dispersants and the like are preferable. These dispersants have a nitrogen atom, the nitrogen atom has an affinity for the pigment surface, and the moiety other than the nitrogen atom increases the affinity for the medium, and thereby dispersion stability is enhanced.
These dispersants may be used singly, or two or more types thereof may be used in combination.

Examples of commercially available products of the dispersant include: "Efka" series ("Efka 46" etc.) available from BASF SE; "Disperbyk" series and "BYK" series ("BYK-160", "BYK-161", "BYK-2001", etc.) available from BYK Japan KK; "Solsperse" series available from Lubrizol Japan Ltd.; "KP" series available from Shin-Etsu Chemical Co., Ltd.; "POLYFLOW" series available from Kyoeisha Chemical Co., Ltd.; "DISPARLON" Series available from Kusumoto Chemicals, Ltd.; and "AJISPER" series ("AJISPER PB-814" etc.) available from Ajinomoto Fine-Techno Co., Inc.

Examples of the organic solvent used in the preparation of the pigment dispersion liquid include: acetic acid ester-based solvents such as propylene glycol monomethyl ether acetate and propylene glycol monoethyl ether acetate; propionate-based solvents such as ethoxypropionate; aromatic solvents such as toluene, xylene, and methoxybenzene; ether-based solvent such as butyl cellosolve, propylene glycol monomethyl ether, diethylene glycol ethyl ether, and diethylene glycol dimethyl ether; ketone-based solvent such as methyl ethyl ketone, methyl isobutyl ketone, and cyclohexanone; aliphatic hydrocarbonbased solvents such as hexane; nitrogen compound-based solvent such as N,N-dimethylformamide, γ-butyrolactam, and N-methyl-2-pyrrolidone; lactonebased solvents such as γ-butyrolactone; and carbamic acid esters.
These solvents may be used singly, or two or more types thereof may be used in combination.

Examples of the method for preparing the pigment dispersion liquid include a method performing a colorant kneading and dispersion step and a fine dispersion step, and a method performing only fine dispersion step. In the kneading and dispersing step, a colorant, a part of an alkali-soluble resin, and the dispersant, if needed, are mixed and kneaded. Dispersion and at the same time applying strong shearing force by using a kneader can disperse the colorant.
Examples of the machine used for kneading include a two-roll machine, a three-roll machine, a ball mill, a tron mill, a disper, a kneader, a co-kneader, a homogenizer, a blender, and a single or twin-screw extruder.
Refining particle size of the colorant is preferably performed by salt milling method or the like before the above-described kneading is performed.

In the fine dispersion step, a mixture of the composition containing the colorant produced in the kneading and dispersing step and a solvent added thereto, or a mixture of the colorant, the alkali-soluble resin, the solvent, and the dispersant as necessary, is mixed and dispersed together with a dispersion medium for fine particles of glass, zirconia, or ceramic using a disperser, so that the particles of the colorant can be dispersed into a minute state close to the primary particles.

From the viewpoint of improving the transmittance, contrast, and the like of color filters, the average particle size of the primary particles of the colorant is preferably from 10 to 100 nm, and more preferably from 10 to 60 nm. Note that, the average particle size of the colorant is measured by a dynamic light scattering type particle size analyzer, and can be measured by, for example, Nanotrac particle size analyzer "UPA-EX150" or "UPA-EX250" available from NIKKISO CO., LTD.

The composition for a coating material, the photoresist composition, and the color resist composition are described above as examples of the coating composition; however, the coating composition is not limited to these.

Specific examples of application of the coating composition of the present invention include an anti-glare (AG) hard coating material, a low reflection (LR) coating material, a low-refractive-index layer coating material, a high-refractive-index layer coating material, a clear hard coating material, a polymerizable liquid crystal coating material, which are coating materials for screens of various displays such as a liquid crystal display (hereinafter, abbreviated as "LCD"), a plasma display (hereinafter, abbreviated as "PDP"), an organic EL display (hereinafter, abbreviated as "OLED"), and a quantum dot display (hereinafter, abbreviated as "QDD"); a color resist, an ink jet ink, a printing ink, or a coating material for forming pixels of RGB or the like in a color filter (hereinafter, abbreviated as "CF") of LCD or the like; a black resist, an ink jet ink, a printing ink, or a coating material for forming a black matrix, a black column spacer, and a black photo spacer of CF of LCD or the like; a coating material for a transparent protective film used for protecting the CF surface of CF of LCD or the like; a liquid crystal material, a column spacer, and a resin composition for a photo spacer of LCD; a resin composition for pixel partitions, a positive photoresist for forming an electrode, a protective film, an insulting film, a plastic casing, a coating material for plastic casing, and a bezel ink of LCD, PDP, OLED, QDD, and the like; a prism sheet and a light diffusion film as back light members of LCD; a coating material for an organic insulating film of a liquid crystal TFT array of LCD; a coating material for protecting the surface of an internal polarizing plate of LCD; a fluorescent substance of PDP; an organic EL material and a sealing material (a protective film and a gas barrier) of OLED; a quantum dot ink, a sealing material, and a protective film of QDD; a high-refractive-index lens, a low-refractive-index sealing, and LED pixels of a micro (mini) LED display; a positive type photoresist, a chemical amplification type photoresist, an anti-reflection film, a multilayer material (SOC and SOG), a lower layer film, a buffer coat, a developer, a rinse liquid, a pattern fall prevention agent, a polymer residue remover, a chemical liquid such as a cleaning agent, and a nano-imprint release agent, which are used for producing a semiconductor; resin compositions (resin compositions of an epoxy resin, a phenol resin, a polyphenylene ether resin, a liquid crystal polymer, a polyimide resin, a bismaleimide resin, a bisallylnadic imide resin, a benzoxazine resin, and the like), a copper clad laminate, a resin coated copper foil, a build-up film, a passivation film, an interlayer insulating film, a flexible copper clad laminate, and a dry film resist for a semiconductor post-process or a printed wiring board; a color resist for an image sensor; a repellent agent for a solder flux; a dispersant, a coating material, and a green sheet for a multi-layer ceramic capacitor; a cathode material, an anode material, a separator, and an electrolytic solution for a lithium ion battery; an exterior coating material, rubber, an elastomer, glass, a vapor deposition material anchor coat, a head lamp lens, a solid lubricating coating material, a heat radiation board, an interior coating material, a repair coating material for automobiles; wallpaper, a floor material, a kitchen member, a bath room/toilet member for housing equipment; an ink jet ink, an ink for offset printing, an ink for gravure printing, an ink for screen printing, a photoresist for a printing plate making process, a photosensitive material for a lithographic printing plate (PS plate), a package adhesive, and a ballpoint pen ink for printed matters; a primer for plastic film easy adhesion; a water repellant for fibers; an anti-diffusion agent for grease; a cleaning liquid for cleaning the surfaces of various products or parts; a hard coat material for optical recording media such as CD, DVD, and a blue ray disk; a coating material or hard coat material for a casing or screen of a smartphone or a cellular phone; a hard coat material for a transfer film for insert mold (IMD and IMF); a release film; a coating material or coat material for various plastic molded articles such as a casing of home appliance; a printing ink or coating material for various building materials such as a decorative sheet; a coating material for a home window glass; a wood coating material for furniture and the like; a coating material for artificial/synthetic leather; a coat material for rubber rollers of OA apparatuses such as a copying machine and a printer; a glass coat material for reading parts of OA apparatuses such as a copying machine and a scanner; an optical lens for a camera, a video camera, glasses, a contact lens, and the like, or a coating material therefor; a coating material for a windshield and glass of a watch such as a wristwatch; a coating material for windows of various vehicles such as an automobile and railroad vehicle; a coating material for an anti-reflection film of a cover glass or film for a solar cell; a coating material or coat material for a FRP bathtub; PCM for a metal-made building material or housing electric appliance; and a single-layer or multilayer coating composition for a photo-fabrication process or the like.

Because the copolymer of the present invention has excellent surface tension reduction performance, and thus not only the leveling properties but also various functions such as wettability, permeability, washability, water repellency, oil repellency, an anti-fouling property, lubricity, an anti-blocking property, and releasability can be expected. Also, when the copolymer of the present invention is blended with a coating material or coating agent containing fine particles, the dispersibility of the fine particles is improved, and not only the leveling properties but also the function as a dispersant for the fine particles can be expected. In addition, when the copolymer of the present invention is added to an adhesive composition used for an adhesive tape or the like, besides the coating composition described above, not only the leveling properties but also the various functions of reducing peel force, suppressing a variation in peel force, and suppressing peel electrostatic charge can also be expected.

### EXAMPLES

The present invention will be specifically described with reference to Examples and Comparative Examples below.

Note that the present invention is not limited to the following examples.

In Examples and Comparative Examples, the weight average molecular weight (Mw) and the number average molecular weight (Mn) are values based on gel permeation chromatography (GPC) measurement calibrated with polystyrene standards.

The measurement conditions of GPC are as follows.

GPC Measurement Conditions
Measuring instrument: high speed GPC system "HLC-8320GPC" available from Tosoh Corporation
Columns: "TSK GUARDCOLUMN SuperHZ-L" available from Tosoh Corporation + "TSK gel SuperHZM-N" available from Tosoh Corporation + "TSK gel SuperHZM-N" available from Tosoh Corporation + "TSK gel SuperHZM-N" available from Tosoh Corporation + "TSK gel SuperHZM-N" available from Tosoh Corporation
Detector: RI (differential refractometer)
Data processing: "EcoSEC Data Analysis Version 1.07" available from Tosoh Corporation
Column temperature: 40°C
Developing solvent: tetrahydrofuran
Flow rate: 0.35 mL/min
Measurement sample: 7.5 mg of a sample was dissolved in 10 mL of tetrahydrofuran, and the resultant solution was filtered through a microfilter to give a measurement sample.
Sample injection volume: 20 µL
Standard sample: The following monodispersed polystyrenes having known molecular weights were used in accordance with the measurement manual of "HLC-8320GPC".

Monodisperse Polystyrene
"A-300" available from Tosoh Corporation
"A-500" available from Tosoh Corporation
"A-1000" available from Tosoh Corporation
"A-2500" available from Tosoh Corporation
"A-5000" available from Tosoh Corporation
"F-1" available from Tosoh Corporation
"F-2" available from Tosoh Corporation
"F-4" available from Tosoh Corporation
"F-10" available from Tosoh Corporation
"F-20" available from Tosoh Corporation
"F-40" available from Tosoh Corporation
"F-80" available from Tosoh Corporation
"F-128" available from Tosoh Corporation
"F-288" available from Tosoh Corporation

### Synthesis Example 1: Synthesis of Random Copolymer (Main Chain: Acrylate Backbone)

Into a three-necked glass flask purged with nitrogen and equipped with a stirrer, a thermometer, a condenser, and a dropping apparatus, 30.0 g of propylene glycol monomethyl ether acetate as a solvent was fed and, while the propylene glycol monomethyl ether acetate was stirred in a nitrogen stream, the temperature was raised to 75°C.

A reaction solution was separately prepared by mixing 25.0 g of 3-acryloyloxypropyltris(trimethylsiloxy)silane, 12.5 g of polypropylene glycol monoacrylate (the average number of repeating units in propylene glycol: 6), 0.375 g of t-butyl peroxy-2-ethylhexanoate as an initiator, and 7.50 g of propylene glycol monomethyl ether acetate as a solvent. This reaction solution was added dropwise to the aforementioned flask over 120 minutes. After completion of the dropwise addition, the flask was stirred at 75°C for 5 hours, then the temperature was raised to 110°C, and further stirred for 1 hour. After completion of the reaction, the solvent was removed by distillation under reduced pressure to give a random copolymer (1).

As a result of GPC measurement of the molecular weight of the obtained copolymer (1), the weight average molecular weight (Mw) was 15700, and (Mw/Mn) was 1.64. Furthermore, based on the feed ratio of the raw materials, the percentage of the content of the functional group represented by -Si[OSi(CH₃)₃]₃ in the copolymer (1) was 48 mass%.

### Synthesis Example 2: Synthesis of Random Copolymer (Main Chain: Acrylate Backbone)

Into a three-necked glass flask purged with nitrogen and equipped with a stirrer, a thermometer, a condenser, and a dropping apparatus, 25.0 g of propylene glycol monomethyl ether acetate as a solvent was fed and, while the propylene glycol monomethyl ether acetate was stirred in a nitrogen stream, the temperature was raised to 80°C.

A reaction solution was separately prepared by mixing 16.7 g of 3-acryloyloxypropyltris(trimethylsiloxy)silane, 8.33 g of polypropylene glycol monoacrylate (the average number of repeating units in propylene glycol: 6), 0.250 g of t-butyl peroxy-2-ethylhexanoate as an initiator, and 12.5 g of propylene glycol monomethyl ether acetate as a solvent. This reaction solution was added dropwise to the flask described above over 120 minutes. After completion of the dropwise addition, the flask was stirred at 80°C for 5 hours, then the temperature was raised to 110°C, and further stirred for 1 hour. After completion of the reaction, the solvent was removed by distillation under reduced pressure to give a random copolymer (2).

As a result of GPC measurement of the molecular weight of the obtained copolymer (2), the weight average molecular weight (Mw) was 10300, and (Mw/Mn) was 1.45. Furthermore, based on the feed ratio of the raw materials, the percentage of the content of the functional group represented by -Si[OSi(CH₃)₃]₃ in the copolymer (2) was 48 mass%.

### Synthesis Example 3: Synthesis of Block Copolymer (Main Chain: Acrylate Backbone)

Into a three-necked glass flask purged with nitrogen and equipped with a stirrer, a thermometer, and a condenser, 20.0 g of polypropylene glycol monoacrylate (the average number of repeating units in propylene glycol: 6) and 25.0 g of butyl acetate as a solvent were fed and, while the mixture was stirred in a nitrogen stream, the temperature was raised to 60°C. After further charging 0.76 g of N,N,N',N",N"-pentamethyldiethylenetriamine and 0.63 g of copper(I) bromide, inside the flask was kept at 60°C and stirred for 30 minutes. To this reaction solution, 1.42 g of ethyl 2-bromoisobutyrate was added and allowed to react at 50°C for 3 hours in a nitrogen stream, and thus a polymer block of polypropylene glycol monoacrylate was obtained.

To this reaction solution, 40.6 g of 3-acryloyloxypropyltris(trimethylsiloxy)silane was added and allowed to react at 60°C for 20 hours. Methyl ethyl ketone was added, and extraction and washing were performed by using each of 20% citric acid aqueous solution, 5% sodium hydroxide aqueous solution, and 20% sodium chloride aqueous solution. The solvent was removed by distillation under reduced pressure, and thus a block copolymer (3) of a polymer block of polypropylene glycol monoacrylate and a polymer block of 3-acryloyloxypropyltris(trimethylsiloxy)silane was obtained.

As a result of GPC measurement of the molecular weight of the obtained copolymer (3), the weight average molecular weight (Mw) was 113,00, and (Mw/Mn) was 1.44. Furthermore, based on the feed ratio of the raw materials, the percentage of the content of the functional group represented by -Si[OSi(CH₃)₃]₃ in the copolymer (3) was 48 mass%.

### Synthesis Example 4: Synthesis of Random Copolymer (Main Chain: Acrylate Backbone + Methacrylate Backbone)

Into a three-necked glass flask purged with nitrogen and equipped with a stirrer, a thermometer, a condenser, and a dropping apparatus, 25.0 g of propylene glycol monomethyl ether acetate as a solvent was fed and, while the propylene glycol monomethyl ether acetate was stirred in a nitrogen stream, the temperature was raised to 80°C.

A reaction solution was separately prepared by mixing 16.7 g of 3-acryloyloxypropyltris(trimethylsiloxy)silane, 8.33 g of polypropylene glycol monomethacrylate (the average number of repeating units in propylene glycol: 4 to 6), 0.50 g of t-butyl peroxy-2-ethylhexanoate as an initiator, and 12.5 g of propylene glycol monomethyl ether acetate as a solvent. This reaction solution was added dropwise to the flask described above over 120 minutes. After completion of the dropwise addition, the flask was stirred at 80°C for 5 hours, then the temperature was raised to 110°C, and further stirred for 1 hour. After completion of the reaction, the solvent was removed by distillation under reduced pressure, and thus a random copolymer (4) was obtained.

As a result of GPC measurement of the molecular weight of the obtained copolymer (4), the weight average molecular weight (Mw) was 14700, and (Mw/Mn) was 1.78. Furthermore, based on the feed ratio of the raw materials, the percentage of the content of the functional group represented by -Si[OSi(CH₃)₃]₃ in the copolymer (4) was 48 mass%.

### Comparative Synthesis Example 1: Synthesis of Random Copolymer (Main Chain: Methacrylate Backbone + Acrylate Backbone)

Into a three-necked glass flask purged with nitrogen and equipped with a stirrer, a thermometer, a condenser, and a dropping apparatus, 25.0 g of propylene glycol monomethyl ether acetate as a solvent was fed and, while the propylene glycol monomethyl ether acetate was stirred in a nitrogen stream, the temperature was raised to 100°C.

A reaction solution was separately prepared by mixing 16.7 g of 3-methacryloyloxypropyltris(trimethylsiloxy)silane, 8.33 g of polypropylene glycol monoacrylate (the average number of repeating units in propylene glycol: 6), 0.50 g of t-butyl peroxy-2-ethylhexanoate as an initiator, and 12.5 g of propylene glycol monomethyl ether acetate as a solvent. This reaction solution was added dropwise to the flask described above over 120 minutes. After completion of the dropwise addition, the flask was stirred at 80°C for 5 hours, then the temperature was raised to 110°C, and further stirred for 1 hour. After completion of the reaction, the solvent was removed by distillation under reduced pressure, and thus a random copolymer (1') was obtained.

As a result of GPC measurement of the molecular weight of the obtained copolymer (1'), the weight average molecular weight (Mw) was 16400, and (Mw/Mn) was 2.13. Furthermore, based on the feed ratio of the raw materials, the percentage of the content of the functional group represented by -Si[OSi(CH₃)₃]₃ in the copolymer (1') was 48 mass%.

### Comparative Synthesis Example 2: Synthesis of Random Copolymer (Main Chain: Methacrylate Backbone + Methacrylate Backbone)

Into a three-necked glass flask purged with nitrogen and equipped with a stirrer, a thermometer, a condenser, and a dropping apparatus, 60.0 g of butyl acetate as a solvent was fed and, while the butyl acetate was stirred in a nitrogen stream, the temperature was raised to 100°C.

A reaction solution was separately prepared by mixing 40.0 g of 3-methacryloyloxypropyltris(trimethylsiloxy)silane, 20.0 g of polypropylene glycol monomethacrylate (the average number of repeating units in propylene glycol: 4 to 6), 1.2 g of t-butyl peroxy-2-ethylhexanoate as an initiator, and 22.9 g of butyl acetate as a solvent. This reaction solution was added dropwise to the flask described above over 120 minutes. After completion of the dropwise addition, the flask was stirred at 100°C for 4 hours, then the temperature was raised to 110°C, and further stirred for 1 hour. After completion of the reaction, the solvent was removed by distillation under reduced pressure, and thus a random copolymer (2') was obtained.

As a result of GPC measurement of the molecular weight of the obtained copolymer (2'), the weight average molecular weight (Mw) was 18000, and (Mw/Mn) was 1.86. Furthermore, based on the feed ratio of the raw materials, the percentage of the content of the functional group represented by -Si[OSi(CH₃)₃]₃ in the copolymer (2') was 48 mass%.

### Comparative Synthesis Example 3: Synthesis of Block Copolymer (Main Chain: Methacrylate Backbone + Methacrylate Backbone)

Into a three-necked glass flask purged with nitrogen and equipped with a stirrer, a thermometer, and a condenser, 75.0 g of methyl ethyl ketone as a solvent and 16.5 g of polypropylene glycol monomethacrylate (the average number of repeating units in propylene glycol: 4 to 6) were fed and, while the mixture was stirred in a nitrogen stream, the temperature was raised to 60°C. 4.24 g of 2,2'-bipyridyl, 2.31 g of N,N,N',N",N"-pentamethyldiethylenetriamine, 1.21 g of copper(l) chloride, and 0.303 g of copper(I) bromide were further fed, and the mixture was stirred for 30 minutes while the temperature in the flask was maintained at 50°C. To this reaction solution, 2.65 g of ethyl 2-bromoisobutyrate was added and allowed to react at 50°C for 5 hours in a nitrogen stream, and thus a polymer block of polypropylene glycol monomethacrylate was obtained.

To this reaction solution, 33.5 g of 3-methacryloyloxypropyltris(trimethylsiloxy)silane was added and allowed to react at 50°C for 18 hours. To the reaction solution, 30 g of activated alumina was added and stirred. After the activated alumina was filtered, the solvent was removed by distillation under reduced pressure, and thus a block copolymer (3') of a polymer block of polypropylene glycol monomethacrylate and a polymer block of 3-methacryloyloxypropyltris(trimethylsiloxy)silane was obtained.

As a result of GPC measurement of the molecular weight of the obtained copolymer (3'), the weight average molecular weight (Mw) was 8300, and (Mw/Mn) was 1.19. Furthermore, based on the feed ratio of the raw materials, the percentage of the content of the functional group represented by -Si[OSi(CH₃)₃]₃ in the copolymer (3') was 48 mass%.

### Examples 1-3 and Comparative Examples 1-2: Preparation and Evaluation of Coating Composition

A coating composition was prepared by mixing 3.0 g of 40 mass% resin solution of alkali-soluble resin (ACRYDIC ZL-295, available from DIC Corporation), 1.2 g of ARONIX M-402 (available from Toagosei Co., Ltd.; mixture of dipentaerythritol pentaacrylate and dipentaerythritol hexaacrylate), 0.0005 g, in terms of solids content, of a copolymer listed in Table 1 below as a leveling agent, and 3.8 g of propylene glycol monomethyl ether acetate (PGMEA).

### Leveling Properties

Onto the central area of a 10 cm × 10 cm chrome-plated glass substrate, 3 ml of the obtained coating composition was dropped, and spin coating was performed under the conditions of a rotation speed of 400 rpm and a rotation time of 20 seconds, followed by heating and drying at 100°C for 100 seconds, and thus a laminate including a coating film layer was prepared.

The film thicknesses of 400 points in a 7 × 7 cm central area of the coating film layer of the obtained laminate were measured by a reflection spectroscopic thickness monitor ("FE-3000" available from Otsuka Electronics Co., Ltd.), a standard deviation thereof was calculated, and thus smoothness of the coating film layer was evaluated based on the following criteria. The results are presented in Table 1.
AA: The standard deviation of the film thicknesses is less than 150
A: The standard deviation of the film thicknesses is 150 or more and less than 200
B: The standard deviation of the film thicknesses is 200 or more and less than 250
C: The standard deviation of the film thicknesses is 250 or more

**[Table 1]**

| | Example 1 | Example 2 | Example 3 | Comparative Example 1 | Comparative Example 2 |
|---|---|---|---|---|---|
| Leveling agent [silicone monomer/miscible monomer] | Copolymer (1) [Ac/Ac] | Copolymer (2) [Ac/Ac] | Copolymer (4) [Ac/Mc] | Copolymer (1') [Mc/Ac] | Copolymer (2') [Mc/Mc] |
| Leveling properties | AA | A | A | C | C |

In Table 1, "Ac" means a "monomer whose polymerizable unsaturated group is an acrylate group", and "Mc" means a "monomer whose polymerizable unsaturated group is a methacrylate group". For example, the copolymer (4) of Example 3 means that the silicone monomer is an acrylate monomer and the miscible monomer is a methacrylate monomer.

From the results of Table 1, it was found that the copolymers in which the structure derived from the silicone monomer was an acrylate backbone each achieved excellent leveling properties even when added in small amounts compared to the copolymers in which the structure derived from the silicone monomer was the methacrylate backbone.

### Examples 4-5, Reference Example 1, and Comparative Examples 3-4: Preparation and Evaluation of Coating Composition

Each coating composition was prepared in a similar manner as in Example 1 by using a copolymer listed in Table 2 below as a leveling agent. By using the obtained coating composition, the pin mura evaluation was performed by the following method. The results are presented in Table 2.

### Evaluation of Pin Mura

Onto the central area of a 10 cm × 10 cm chrome-plated glass substrate, 3 ml of the obtained coating composition was dropped, and spin coating was performed under the conditions of a rotation speed of 400 rpm and a rotation time of 20 seconds, and thus a coating base material was obtained. Pins made of SUS were placed on four corners of a hot plate, the obtained coating base material was placed on the supporting pins and heated and dried at 100°C for 100 seconds, and thus a laminate having a coating film layer was prepared.

The coating film layer of the obtained laminate was visually observed, and the pin mura of the coating film layer was evaluated according to the following criteria. The results are presented in Table 2. Note that the term "pin mura" refers to unevenness in film thickness (unevenness after drying) caused around the part where supporting pins and a coating base material are in contact with each other.
∘: Almost no unevenness in film thickness is observed around a pin
×: Unevenness in film thickness is observed around a pin

**[Table 2]**

| | Example 4 | Example 5 | Reference Example 1 | Comparative Example 3 | Comparative Example 4 |
|---|---|---|---|---|---|
| Leveling agent [silicone monomer/miscible monomer] | Copolymer (1) [Ac/Ac] | Copolymer (2) [Ac/Ac] | Copolymer (4) [Ac/Mc] | Copolymer (1') [Mc/Ac] | Copolymer (2') [Mc/Mc] |
| Pin mura | ○ | ○ | × | × | × |

From the results of Table 2, it was found that a case of the copolymer in which the structure derived from the silicone monomer was an acrylate backbone and the structure derived from the miscible monomer was also an acrylate backbone also achieved the pin mura suppression effect.

### Example 5, Reference Example 2, and Comparative Example 5: Preparation and Evaluation of Coating Composition

Each coating composition was prepared in a similar manner as in Example 1 by using a copolymer listed in Table 3 below as a leveling agent. By using the obtained coating composition, the leveling property evaluation and the pin mura evaluation described above were performed. The results are presented in Table 3. In addition, recoatability was also evaluated by the following method. The results are presented in Table 3.

### Recoatability

Onto the central area of a 10 cm × 10 cm chrome-plated glass substrate, 3 ml of the obtained coating composition was dropped, and spin coating was performed under the conditions of a rotation speed of 1000 rpm and a rotation time of 10 seconds, followed by heating and drying at 100°C for 100 seconds, and thus a laminate including a coating film layer was prepared.

Onto the coating film layer of the obtained laminate, 2 µL of propylene glycol monomethyl ether acetate (PGMEA) was dropped. By using a contact angle meter ("MODEL CA-W701" available from Kyowa Interface Science Co., Ltd.), the contact angle after passage of time of the PGMEA at 20 seconds after the dropping was measured and evaluated by the following criteria.

Note that the PGMEA contact angle means wettability of the coating film layer, and a smaller PGMEA contact angle means superior recoatability. AA: The PGMEA contact angle is 10 degrees or less
A: The PGMEA contact angle is 10 degrees or more and less than 11 degrees
B: The PGMEA contact angle is 11 degrees or more and less than 12 degrees
C: The PGMEA contact angle is 12 degrees or more

**[Table 3]**

| | Example 5 | Reference Example 2 | Comparative Example 5 |
|---|---|---|---|
| Leveling agent [silicone monomer/miscible monomer] | Copolymer (3) [Ac/Ac] | Copolymer (2) [Ac/Ac] | Copolymer (3') [Mc/Mc] |
| Form of Polymerization of Copolymer | Block | Random | Block |
| Leveling properties | A | A | B |
| Pin mura | ○ | ○ | × |
| Recoatability | AA | B | B |

From the results of Table 3, it was found that a case of the block copolymer in which the structure derived from the silicone monomer was an acrylate backbone and the structure derived from the miscible monomer was also an acrylate backbone also improved the recoatability.

## Claims

1. A copolymer, comprising at least a polymerizable monomer (a1) and a polymerizable monomer (a2) as polymerizable components: the polymerizable monomer (a1) containing a functional group represented by - Si[OSi(R)₃]ₙ[R']₃₋ₙ, (where n is an integer in a range of from 1 to 3, R each independently represents an alkyl group having from 1 to 3 carbon atoms, and R' each independently represents an alkyl group having from 1 to 3 carbon atoms) and an acryloyl group; and the polymerizable monomer (a2) containing one or more selected from the group consisting of an alkyl group having from 1 to 18 carbon atoms, an aromatic group having from 6 to 18 carbon atoms, a group containing a polyoxyalkylene chain, and a group containing a polyester chain.

2. The copolymer according to claim 1, wherein the polymerizable monomer (a1) is a compound represented by Formula (a1-1) set forth below: 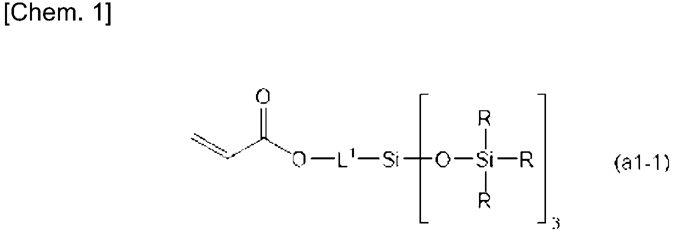 (where in Formula (a1-1),
R each independently represents an alkyl group having from 1 to 3 carbon atoms, and L¹ is a divalent organic group or a single bond).

3. The copolymer according to claim 1 or 2, wherein the polymerizable monomer (a2) is one or more selected from the group consisting of: a compound represented by Formula (a2-1), a compound represented by Formula (a2-2), a compound represented by Formula (a2-3), and a compound represented by Formula (a2-4): 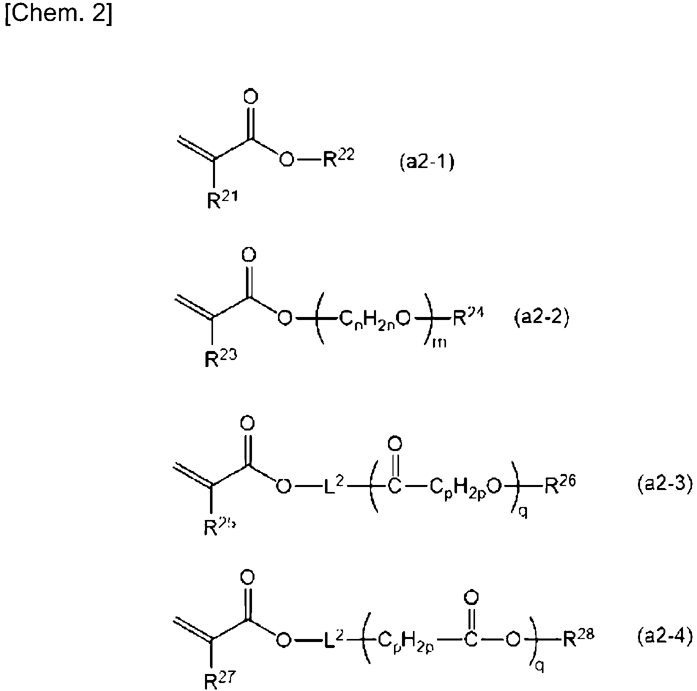 (where in Formulas (a2-1), (a2-2), (a2-3), and (a2-4),
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms, R²⁵ is a hydrogen atom or a methyl group,
R²⁶ is a hydrogen atom, an alkyl group having from 1 to 18 carbon atoms, or an alkyl group containing an ether bond having from 1 to 18 carbon atoms,
R²⁷ is a hydrogen atom or a methyl group,
R²⁸ is a hydrogen atom, an alkyl group having from 1 to 18 carbon atoms, or an alkyl group containing an ether bond having from 1 to 18 carbon atoms,
L² is a divalent organic group or a single bond, and
n is an integer in a range of from 1 to 4, m represents the number of repeating units, p is an integer in a range of from 1 to 10, and q represents the number of repeating units).

4. The copolymer according to claim 3, wherein R²¹, R²³, R²⁵, and R²⁷ are each a hydrogen atom.

5. The copolymer according to claim 1 or 2, wherein a percentage of content of the functional group represented by -Si[OSi(R)₃]ₙ[R']₃₋ₙ is in a range of from 20 mass% to 80 mass% of a total amount of the polymerizable components.

6. The copolymer according to claim 1 or 2, wherein 50 mass% or more of the polymerizable components other than the polymerizable monomer (a1) comprises a polymerizable monomer containing an acryloyl group as a polymerizable unsaturated group.

7. The copolymer according to claim 1 or 2, comprising no fluorine atom.

8. The copolymer according to claim 1 or 2, wherein the copolymer is a block copolymer comprising a polymer block of the polymerizable monomer (a1) and a polymer block of the polymerizable monomer (a2).

9. The copolymer according to claim 1 or 2, wherein a number average molecular weight is in a range of from 1000 to 500000.

10. The copolymer according to claim 1 or 2, which is a leveling agent.

11. A coating composition, comprising the copolymer according to claim 1 or 2.

12. A coating film, comprising the coating composition according to claim 10.

13. A resist composition, comprising the copolymer according to claim 1 or 2.

14. The resist composition according to claim 13, wherein an alkali-soluble resin is contained, and per 100 parts by mass of the alkali-soluble resin, content of the copolymer is 0.05 parts by mass or less.

15. A cured product obtained by curing the resist composition according to claim 13.

16. An article, comprising the copolymer according to claim 1 or 2.
